(19) Europäisches Patentamt
European Patent Office
Office européen des brevets

(11) **EP 3 210 246 B1**

(12) **FASCICULE DE BREVET EUROPEEN**

(45) Date de publication et mention
de la délivrance du brevet:
**12.12.2018 Bulletin 2018/50**

(21) Numéro de dépôt: **15781110.0**

(22) Date de dépôt: **15.10.2015**

(51) Int Cl.:
*H01L 45/00* (2006.01)      *H01L 27/22* (2006.01)
*H01L 27/24* (2006.01)      *C23C 14/34* (2006.01)
*H01L 21/4763* (2006.01)

(86) Numéro de dépôt international:
**PCT/EP2015/073897**

(87) Numéro de publication internationale:
**WO 2016/062613 (28.04.2016 Gazette 2016/17)**

(54) **PROCÉDÉ DE FABRICATION D'UN DISPOSITIF RÉSISTIF POUR CIRCUIT MÉMOIRE OU LOGIQUE**

VERFAHREN ZUR HERSTELLUNG EINER WIDERSTANDSFÄHIGEN VORRICHTUNG FÜR EINEN SPEICHER ODER EINE LOGISCHE SCHALTUNG

METHOD FOR MANUFACTURING A RESISTIVE DEVICE FOR A MEMORY OR LOGIC CIRCUIT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.10.2014 FR 1460073**

(43) Date de publication de la demande:
**30.08.2017 Bulletin 2017/35**

(73) Titulaires:
• **Commissariat à l'Énergie Atomique
et aux Énergies Alternatives
75015 Paris (FR)**
• **Centre National de la Recherche Scientifique
75016 Paris (FR)**
• **Université Grenoble Alpes
38041 Grenoble Cedex 9 (FR)**

(72) Inventeurs:
• **DIENY, Bernard
F-38250 Lans En Vercors (FR)**
• **DARNON, Maxime
F-42410 Pavezin (FR)**
• **NAVARRO, Gabriele
F-38000 Grenoble (FR)**
• **JOUBERT, Olivier
F-38240 Meylan (FR)**

(74) Mandataire: **Cabinet Camus Lebkiri
25 rue de Maubeuge
75009 Paris (FR)**

(56) Documents cités:
**US-A1- 2001 003 678     US-A1- 2008 247 214
US-A1- 2008 280 411     US-A1- 2009 104 779
US-A1- 2010 000 855     US-A1- 2010 108 974
US-A1- 2012 070 693     US-A1- 2014 124 881**

**Description**

**DOMAINE TECHNIQUE**

La présente invention est relative à un dispositif résistif de type mémoire non volatile ou de type logique, comprenant une pluralité d'éléments de stockage de résistance électrique variable appelés également points mémoires ou unités logiques.

**ETAT DE LA TECHNIQUE**

Plusieurs technologies de mémoires non volatiles sont en cours de développement avec des degrés de maturité divers. On peut citer notamment les mémoires à changement de phase PCRAM (« Phase Change Random Access Memory »), les mémoires résistives à pont conducteur CBRAM (« Conductive Bridge RAM ») ou bien à base d'oxyde OxRAM, les mémoires ferroélectriques FeRAM et les mémoires magnétiques MRAM. Hormis les mémoires FeRAM qui fonctionnent selon le principe de l'orientation d'un moment dipolaire électrique dans un matériau ferroélectrique, toutes les autres mémoires utilisent des matériaux de résistance électrique variable. Chaque bit d'information est stocké dans un élément de résistance variable et codé par la valeur de résistance de cet élément de stockage (typiquement le niveau logique '0' correspond à une forte valeur de résistance et le niveau logique '1' correspond à une faible valeur de résistance).

Le mécanisme à l'origine de la variation de résistance dépend de la technologie utilisée. Dans les PCRAM par exemple, il s'agit de matériaux semi-conducteurs chalcogénures que l'on peut faire transiter d'un état amorphe à un état cristallin (ou inversement), par des impulsions de courant d'amplitude et durée appropriées. Dans les MRAM, l'élément de stockage est une jonction tunnel magnétique présentant un effet de magnétorésistance tunnel. Dans les CBRAM, on forme ou on détruit des filaments conducteurs en faisant diffuser des espèces métalliques (par exemple Ag) dans une matrice semi-conductrice (par exemple Ge). Toutes ces formes de mémoire impliquent le passage d'un courant à travers l'élément de stockage, lequel présente une résistance électrique variant entre une valeur minimale et une valeur maximale.

En microélectronique, l'une des techniques couramment utilisée pour graver des matériaux dans des procédés industriels est la gravure plasma réactive. Cette gravure par plasma réactif forme habituellement des composés volatils par réaction entre le matériau gravé et les constituants du plasma (classiquement à base de $Cl_2$, HBr, $SF_6$, $CF_4$, $O_2$, $NH_3$, CO, $CH_3OH$...), ces composés volatils étant ensuite pompés hors de l'enceinte de gravure. Le problème rencontré avec les matériaux des mémoires MRAM (divers matériaux magnétiques et non-magnétiques constituant la jonction tunnel magnétique, par exemple Pt, Pd, CoFe, NiFe, CoFeB, PtMn, IrMn, MgO et NiO), des CBRAM (chalcogénures de type GeSbTe ou InSbTe) et certaines OxRAM ($CaTiO_3$, $PrCaMnO_3$ et autres oxydes de métal de transition) est l'absence de composés volatils ou, au contraire, une gravure trop réactive des matériaux qui rend le contrôle dimensionnel difficile (cas de GeSbTe notamment) et modifie les propriétés des matériaux (par exemple la vitesse de cristallisation de GeSbTe). Quand les résidus de gravure ne sont pas volatils, ils ne peuvent être évacués et se redéposent sur le substrat en cours de gravure. Ces résidus ont également tendance à tapisser les parois du bâti de gravure, conduisant à des problèmes de reproductibilité et de défectivité. De plus, les gaz utilisés pour générer le plasma réactif peuvent corroder les matériaux à graver.

La gravure de ces matériaux « mémoire » peut aussi être réalisée par un bombardement d'ions de gaz neutre, typiquement de l'argon. Toutefois, cette technique, appelée gravure par faisceau d'ions (« Ion Beam Etching », IBE), donne des résultats de qualité insuffisante pour un procédé industriel. En effet, plusieurs problèmes se posent :

- La technique de gravure IBE conduit à un nombre de défauts important aux bords des structures qui forment les éléments de stockage et à une variabilité importante des propriétés électriques ou magnétiques d'un point mémoire à l'autre.
- Les résidus de gravure n'étant pas volatils, ils polluent le substrat et le bâti de gravure, à l'instar de la gravure plasma. En particulier, ils se déposent sur les flancs des structures, ce qui altère les propriétés électriques des éléments de stockage. Par exemple, dans le cas d'une jonction tunnel magnétique, la gravure de l'électrode magnétique supérieure peut entraîner un dépôt métallique sur les flancs de la structure qui court-circuite la barrière tunnel.

- Les éléments de stockage gravés par IBE ont des flancs inclinés, ce qui est gênant pour les applications haute densité où les points mémoire sont très proches les uns des autres.
- Une gravure uniforme sur des substrats de diamètre supérieur ou égal à 300 mm est difficile à obtenir, car le flux d'ions n'est pas homogène sur une telle surface.

Aucune solution n'a donc été trouvée jusqu'à présent pour graver de façon satisfaisante les matériaux des éléments de stockage utilisés dans les mémoires non volatiles MRAM, OxRAM et CBRAM, notamment celles de résolution inférieure à 30 nm. Par ailleurs, les mêmes problématiques se posent dans le domaine des composants logiques, et plus particulièrement des unités logiques magnétiques MLU (« Magnetic Logic Unit ») qui comprennent chacune une jonction tunnel magnétique gravée par IBE ou gravure plasma réactive.

Le procédé « damascène » constitue une alternative à la gravure plasma (IBE ou plasma réactive) pour structurer les éléments de stockage des mémoires MRAM, CBRAM et OxRAM. Ce procédé, habituellement utilisé pour la fabrication des interconnections métalliques de circuits intégrés, consiste à définir l'empreinte de l'élément dans un matériau isolant, puis à déposer les matériaux (magnétiques, chalcogénures, oxydes... suivant la technologie de mémoire visée) sur l'ensemble du substrat. Un polissage mécano-chimique permet de supprimer l'excès de matériaux en dehors de l'empreinte.

Le document US6153443 donne un exemple de mémoire MRAM obtenue grâce au procédé « damascène ». Chaque point mémoire est constitué d'une jonction tunnel magnétique connectée à un transistor de sélection par l'intermédiaire d'un via et d'une ligne métallique. Le transistor est réalisé en technologie CMOS classique, tandis que le via et la jonction tunnel sont réalisés grâce au procédé « damascène ». Les différentes couches de la jonction tunnel sont déposées dans des cavités préalablement formées dans un matériau isolant.

Ainsi, le procédé « damascène » permet de s'affranchir de la gravure des matériaux mémoire. Toutefois, les dépôts successifs de matériaux sur les flancs des cavités réduisent la surface effective de l'élément de stockage et rendent difficile le contrôle de l'épaisseur des couches déposées sur ces flancs. Ceci est particulièrement vrai pour les MRAM qui peuvent empiler un grand nombre de couches magnétiques et non magnétiques de très faible épaisseur, la couche de barrière tunnel ayant par exemple une épaisseur de l'ordre de 1 nm. Si l'épaisseur de la couche barrière devient trop faible au niveau des flancs des cavités, des courts-circuits électriques peuvent apparaitre à travers cette barrière rendant la jonction tunnel inutilisable.

Le document US2014/0124881 décrit une mémoire résistive de type MRAM, PCRAM ou OxRAM agencée sous la forme d'une matrice de points mémoire. Cette mémoire comprend une pluralité de piliers conducteurs disposés verticalement sur un substrat semi-conducteur et espacés les uns des autres. Ces piliers conducteurs supportent chacun un élément de stockage. Les piliers ont des flancs rectilignes ou en arc de cercle et une section à leur base plus petite qu'à leur sommet. La forme de ces piliers permet de discrétiser la couche de stockage lors de son dépôt, évitant ainsi d'avoir à la graver. Les piliers sont formés pas le procédé « damascène » et la couche de stockage est déposée par pulvérisation cathodique, après retrait partiel du diélectrique situé entre les piliers. Malgré l'absence de gravure, ce procédé de structuration génère dans les points mémoire (ou points logiques) des défauts structuraux et/ou chimiques, qui conduisent une forte variabilité des propriétés de point à point, en particulier une forte dispersion des propriétés électriques et de la rétention du point mémoire (c'est-à-dire sa capacité à garder l'information dans le temps). Cette dispersion est d'autant plus forte que la taille des points est petite, puisque les défauts apparaissent la plupart du temps à la périphérie des points.

Le document US 2008 / 0280411 A1 décrit également un procédé connu.

## RESUME DE L'INVENTION

Il existe donc un besoin de prévoir un procédé de fabrication d'un dispositif résistif conduisant à une plus faible variabilité des propriétés électriques et de rétention entre les éléments de stockage.

Selon l'invention, on tend à satisfaire ce besoin en prévoyant un procédé de fabrication de dispositif résistif comprenant les étapes suivantes :

- déposer une première couche électriquement conductrice sur un substrat ;
- former un masque de gravure sur la première couche conductrice ;
- graver au travers du masque la première couche conductrice, de sorte à obtenir une pluralité de piliers électriquement conducteurs espacés les uns des autres ;
- former des éléments de stockage de résistance électrique variable aux sommets des piliers conducteurs, de sorte que chaque élément de stockage est supporté par l'un des piliers conducteurs,

l'étape de formation des éléments de stockage comprenant les opérations suivantes :

◦ déposer une première couche par pulvérisation cathodique non-collimatée sous une incidence normale par rapport au substrat ; et
◦ déposer par pulvérisation cathodique une deuxième couche sur la première couche, la deuxième couche comprenant une première espèce chimique pulvérisée sous une incidence oblique.

De façon alternative, le procédé de fabrication peut comprendre les étapes suivantes :

- former des structures verticales d'interconnexion de type damascène en matériau conducteur électriquement sur un substrat, lesdites structures verticales d'interconnexion étant réparties au sein d'une couche diélectrique ;
- amincir la couche diélectrique de sorte à libérer au moins partiellement lesdites structures verticales d'interconnexion ; et
- former des éléments de stockage de résistance électrique variable aux sommets des structures verticales d'interconnexion, de sorte que chaque élément de stockage est supporté par l'une des structures verticales d'interconnexion,

l'étape de formation des éléments de stockage comprenant les opérations suivantes :

∘ déposer une première couche par pulvérisation cathodique non-collimatée sous une incidence normale par rapport au substrat ; et

∘ déposer par pulvérisation cathodique une deuxième couche sur la première couche, la deuxième couche comprenant une première espèce chimique pulvérisée sous une incidence oblique.

Selon un développement du procédé de fabrication, la deuxième couche des éléments de stockage comprend une deuxième espèce chimique différente de la première espèce chimique et pulvérisée sous une incidence normale par rapport au substrat en même temps que la première espèce chimique.

De préférence, le substrat est entraîné en rotation lorsque la première espèce chimique est pulvérisée sous une incidence oblique

**BREVES DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente un premier mode de réalisation d'un dispositif résistif à piliers évasés selon l'invention ;
- la figure 2 représente un deuxième mode de réalisation d'un dispositif résistif à piliers évasés selon l'invention ;
- la figure 3 représente schématiquement un substrat sur lequel peut être fabriqué le dispositif résistif selon l'invention ;
- les figures 4A à 4G représentent des étapes F1 à F7 d'un procédé de fabrication d'un dispositif résistif selon l'invention ;
- la figure 5 illustre une variante de mise en oeuvre des étapes F6 et F7 ;
- la figure 6 représente un exemple de dispositif résistif dans lequel les piliers évasés sont formés par des structures d'interconnexion de type « damascène », d'après un troisième mode de réalisation de l'invention ;
- les figures 7A à 7C représentent des étapes F1' à F3' d'un procédé de fabrication du dispositif résistif selon le troisième mode de réalisation de l'invention ;
- la figure 8 représente un autre exemple de dispositif résistif dans lequel les piliers évasés sont de type « damascène », fabriqué grâce au procédé « double damascène » ;
- les figures 9A à 9C représentent la formation d'un premier exemple d'élément de stockage présentant une variation locale d'épaisseur ;
- les figures 10A et 10B représentent la formation d'un second exemple d'élément de stockage présentant une variation locale d'épaisseur ;

- les figures 11A et 11B représentent la formation d'un premier exemple d'élément de stockage présentant une variation locale de composition chimique ;
- les figures 12A et 12B représentent la formation d'un second exemple d'élément de stockage présentant une variation locale de composition chimique ;
- les figures 13A à 13F représentent des étapes S1 à S6 d'un procédé de fabrication d'un dispositif résistif hybride MRAM/PCRAM confinée selon l'invention ;
- la figure 14 représente deux points mémoire adjacents du dispositif résistif hybride MRAM/PCRAM confinée selon le plan de coupe A-A de la figure 13F ; et
- la figure 15 représente une variante de mise en oeuvre de l'étape S5 de la figure 13E.

Pour plus de clarté, les éléments identiques ou similaires sont repérés par des signes de référence identiques sur l'ensemble des figures.

**DESCRIPTION DETAILLEE D'AU MOINS UN MODE DE REALISATION**

Dans la description qui suit, on nomme « matériau résistif » le ou les matériaux qui constituent l'élément de stockage de résistance variable. Il peut s'agir d'un matériau conducteur jouant le rôle d'électrode ou du matériau actif, c'est-à-dire celui qui remplit la fonction de stockage (ou mémoire).

Afin de structurer plus facilement les éléments de stockage, et donc d'obtenir des éléments de meilleure facture, un substrat présentant une pluralité de piliers électriquement conducteurs en forme de mesa est utilisé. Ces piliers, ou plots, sont espacés les uns des autres et présentent des flancs surplombants, de sorte que lorsqu'on dépose chaque matériau résistif de l'élément de stockage, la couche de ce matériau se discrétise aux sommets des piliers et entre les piliers. Autrement dit, ce substrat permet de structurer naturellement les éléments de stockage aux sommets des piliers, sans qu'on ait besoin de graver a posteriori le matériau résistif.

Les piliers ont une forme évasée (au moins partiellement) et une section à leur base plus petite qu'à leur sommet. Ils sont suffisamment isolés électriquement les uns des autres, malgré la présence de matériau résistif au fond des tranchées séparant les piliers, grâce au fait que le matériau ne recouvre pas les flancs à la base des piliers. En effet, le dépôt du matériau résistif s'effectuant selon un procédé sensiblement directif, de préférence par dépôt physique en phase vapeur (PVD) tel que la pulvérisation cathodique ou l'évaporation, la partie supérieure en surplomb de chaque pilier empêche par effet d'ombrage le dépôt du matériau au pied des flancs.

Puisqu'on s'affranchit de l'étape de gravure du matériau résistif par IBE ou gravure plasma, les éléments de stockage contiennent moins de défauts structurels ou chimiques sur les bords (habituellement causés par IBE ou gravure plasma réactive). Par conséquent, le dispositif résistif selon l'invention présente moins de variabilité d'un point mémoire à l'autre en termes de performances. En outre, les éléments de stockage ne risquent pas d'être corrodés comme c'est généralement le cas avec une gravure par plasma réactif. Leurs parois latérales peuvent être verticales, plutôt qu'inclinées, du fait de l'absence de résidus de gravure.

Enfin, comme il sera décrit en détail ci-après, le fait de déposer le matériau résistif sur des plots préalablement gravés permet de jouer sur les incidences de dépôt, afin de créer des gradients latéraux d'épaisseur ou de composition chimique à l'échelle de chaque plot.

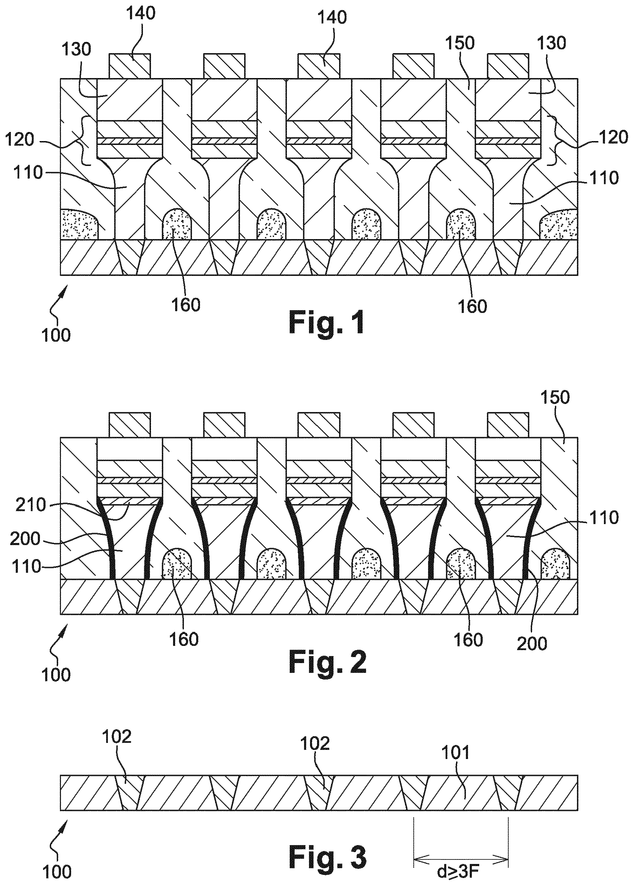

La figure 1 représente, en vue de coupe, un premier mode de réalisation d'un dispositif résistif où les éléments de stockage de résistance variable sont supportés par des piliers évasés et conducteurs.

Le dispositif résistif comprend un substrat 100 sur lequel est disposé un ensemble de piliers 110 en matériau électriquement conducteur, par exemple en tantale. Les piliers 110 sont orientés à la verticale par rapport au plan du substrat 100. De préférence, leur section, mesurée dans un plan parallèle au substrat 100, varie de façon strictement croissante de la base au sommet des piliers. Autrement dit, la section des piliers 110 est minimale à leur base et maximale à leur sommet.

Le dispositif comporte en outre une pluralité d'éléments de stockage 120 disposés aux sommets des piliers 110. Dans le cas des applications de type mémoire, ces éléments de stockage 120 présentent une résistance électrique variant entre deux états, un état faiblement résistif et un état fortement résistif, en réponse à un stimulus électrique. Ils peuvent donc former des points mémoire (de type CBRAM, MRAM, OxRAM...) ou des unités logiques (magnétiques notamment). Ils peuvent être formés d'une ou plusieurs couches, dont le ou les matériaux varient selon la nature du dispositif à réaliser, par exemple selon le type de mémoire envisagé. Dans le cas des applications de type memristor, on utilise des valeurs intermédiaires de la résistance situées entre l'état faiblement résistif et l'état fortement résistif.

Chaque élément de stockage 120 est supporté par l'un des piliers conducteurs 110. De préférence, le dispositif résistif comprend autant de piliers 110 qu'il y a d'éléments de stockage 120, c'est-à-dire de points mémoire (pour les applications mémoire) ou d'unités logiques (pour les applications logiques). Les piliers 110 ont, de préférence, une forme et des dimensions identiques. Ils sont généralement arrangés en lignes et en colonnes sur le substrat 100, pour former une matrice de points mémoire.

Au-dessus de chaque élément de stockage 120, le dispositif résistif comporte avantageusement un élément de couverture 130 en matériau électriquement conducteur, qui facilite la prise de contact électrique au niveau de l'élément de stockage 120. Comme l'élément de stockage, cet élément de couverture 130 se limite à la face supérieure du pilier 110 qui le supporte. Le matériau des éléments de couverture 130 peut être identique ou différent de celui des piliers conducteurs 110. Enfin, un contact électrique 140 est disposé sur chaque élément de couverture 130 et permet d'acheminer le courant vers l'élément de stockage 120 (par l'intermédiaire de l'élément de couverture 130).

Comme cela est représenté sur la figure 1, les structures verticales formées par les piliers conducteurs 110, les éléments de stockage 120 et les éléments de couverture 130 superposés sont avantageusement noyées dans un matériau diélectrique 150 qui renforce la solidité d'un point de vue mécanique de l'ensemble des piliers et éléments de stockage, et qui permet en outre la réalisation de la prise de contact électrique au sommet de la couche 130.

Enfin, il subsiste sur le substrat 100 des dépôts résiduels 160 de matériau(x) résistif(s) formant les éléments de stockage 120. Ces dépôts résiduels 160 ont une forme irrégulière du fait des effets d'ombrage créés par les bords en saillie des piliers 110. Ils sont situés entre les piliers conducteurs 110 et sont inactifs électriquement. Ils ne perturbent donc pas le fonctionnement du dispositif.

Dans ce premier mode de réalisation, les flancs des piliers 110 ont un profil à encoche (« notch » en anglais). La section de chaque pilier 110 est d'abord constante dans une partie inférieure du pilier, puis augmente brusquement dans sa partie supérieure, à proximité du sommet. Cette variation de section peut être continue, comme illustrée sur la figure 1, ou bien discontinue.

La figure 2 représente un deuxième mode de réalisation, dans lequel les flancs des piliers 110 ont une forme en arc de cercle ou « tonneau » (« bowing ») et sont recouverts d'une couche 200 en matériau électriquement isolant. La section des piliers varie de façon continue, par exemple en augmentant de la base au sommet des piliers comme cela est illustré sur la figure 2. Autrement, la section peut légèrement diminuer à partir de la base des piliers puis augmenter au fur et à mesure qu'on se rapproche du sommet. En d'autres termes, la section minimale des piliers n'est pas nécessairement celle à la base des piliers.

De façon plus générale, les piliers peuvent être de formes variées suivant la technologie utilisée. En particulier, leur section peut être ronde, elliptique, carrée ou rectangulaire.

La couche isolante 200 recouvre au moins la portion de flanc située à la base des piliers 110, en regard des dépôts résiduels 160 de matériau résistif, et de préférence la totalité des flancs. Elle améliore l'isolation électrique entre les différents piliers 110. Elle s'avère particulièrement avantageuse lorsque les flancs sont faiblement surplombants, c'est-à-dire lorsque la section au sommet n'est que légèrement supérieure à la section à la base. Dans cette situation, le dépôt résiduel 160 situé entre deux piliers 110 voisins peut être conséquent et, s'il l'on ne prend pas garde au choix du matériau diélectrique 150, il existe un risque de court-circuit entre ces deux piliers. Ce risque (ou les contraintes sur le choix du matériau diélectrique 150) est ici éliminé au moyen de la couche isolante 200. Par contre, lorsque les flancs sont fortement surplombants, la couche isolante 200 n'est pas obligatoire, car le dépôt résiduel 160 est davantage éloigné des piliers 110.

Pour éviter que le dépôt résiduel 160 entre les piliers ne touche la base des piliers 110, il est préférable que la projection verticale dans le plan du substrat de la section la plus large de chaque pilier dépasse d'au moins 2 nm dans toutes les directions de la section du pilier à sa base. Cette valeur peut dépendre de la directivité du dépôt de l'élément résistif mais constitue une limite inférieure pour le cas d'un dépôt relativement directif comme celui obtenu par évaporation. On se trouve alors dans la situation où la couche isolante 200 sur les flancs des piliers 110 est facultative - car l'isolation (par espacement entre piliers et dépôt résiduel) est déjà suffisante.

Par ailleurs, dans ce deuxième mode de réalisation, le dispositif comporte une couche protectrice 210 située aux sommets des piliers 110, à l'interface entre chaque pilier 110 et l'élément de stockage 120 correspondant. Cette couche protectrice 210 empêche, lorsqu'on forme la couche 200 sur les flancs des piliers 110, de produire simultanément un matériau isolant sur leur face supérieure. Autrement dit, la couche protectrice garantit la continuité électrique entre chaque pilier conducteur 110 et l'élément de stockage 120 disposé sur cette face supérieure. Elle est, de préférence, formée d'un métal noble ou d'un oxyde/nitrure conducteur électriquement, par exemple l'oxyde de ruthénium (RuO).

Les spécificités de chaque mode de réalisation, décrites ci-dessus en relation avec les figures 1 et 2, peuvent bien sûr être combinées en elles. A titre d'exemple, les flancs des piliers 110 peuvent être en forme d'encoche et recouverts de la couche isolante 200.

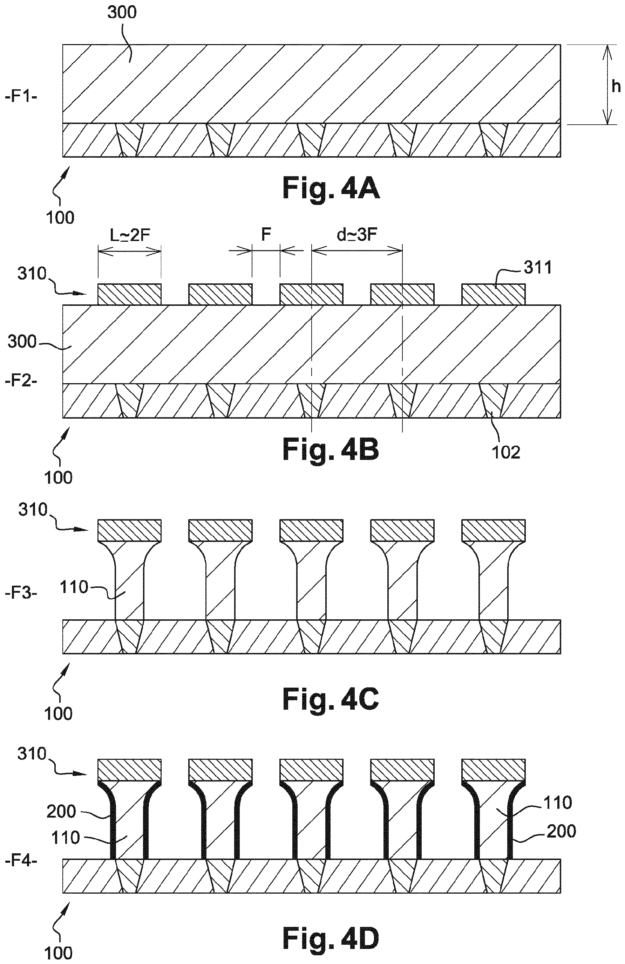

Un procédé de fabrication d'un dispositif résistif selon l'un quelconque de ces modes de réalisation va maintenant être décrit en référence aux figures 3, 4A à 4G. La figure 3 montre le substrat 100 qui sert de point de départ au procédé de fabrication, tandis que les figures 4A à 4G représentent des étapes F1 à F7 de ce procédé.

Le substrat 100 comporte classiquement un circuit CMOS capable d'adresser chaque point mémoire et lire la donnée enregistrée dans l'élément de stockage, soit la valeur de résistance électrique de cet élément. Ce circuit comporte par exemple des transistors de sélection connectés électriquement aux piliers conducteurs par un ou plusieurs niveaux d'interconnexion. Sur la figure 3, on a représenté en coupe transversale uniquement le dernier niveau d'interconnexion avant les points mémoire. Il est formé d'une couche en matériau diélectrique 101 (par exemple en $SiO_2$ ou $Al_2O_3$) traversée par des motifs d'interconnexion 102, tels que des via conducteurs ou des lignes conductrices, typiquement en métal (cuivre, aluminium...). Ces motifs d'interconnexion 102 permettent de relier électriquement les éléments de stockage au circuit CMOS.

Pour les applications mémoire non volatile, on cherche généralement à intégrer les éléments de stockage aussi haut que possible dans l'empilement, afin d'optimiser le processus de fabrication. De préférence, les piliers conducteurs du dispositif résistif sont formés au-dessus de l'un des derniers niveaux de métal.

Les via conducteurs (ou lignes conductrices) 102 sont (dans les technologies actuelles) typiquement éloignés d'une distance d supérieure ou égale à 3F, où F désigne la résolution du dispositif résistif, c'est-à-dire la dimension minimale atteignable par lithographie (« half-pitch » en anglais). Cette valeur de 3F correspond par exemple en technologie CMOS à la distance séparant deux via émergents consécutifs de transistors MOSFET. Le substrat 100 qui sert de support aux piliers 110 occupe généralement toute la surface du circuit mémoire à fabriquer. Toutefois, dans le cas d'un circuit hybride mémoire/logique, le substrat 100 peut correspondre à une portion seulement du circuit. Le reste du circuit est alors protégé pendant la fabrication des points mémoire par un matériau isolant ou par un matériau sacrificiel, qui sera retiré en cours ou à la fin du procédé de fabrication du circuit.

Bien entendu, comme n'importe quel niveau de métal du substrat, le niveau d'interconnexion de la figure 3 peut comporter d'autres motifs (type via ou ligne) que ceux destinés à relier électriquement les piliers 110 (et référencés 102). Par exemple, ces autres motifs peuvent relier un niveau inférieur à un niveau supérieur à celui des éléments de stockage ou deux transistors MOS situés plus bas dans le substrat. Dans le cas de lignes, ils ne sont d'ailleurs pas nécessairement traversants.

Les étapes F1 à F7 décrites ci-dessous en relation avec les figures 4A à 4G permettent de réaliser, sur ce substrat de départ 100, des nanostructures résistives connectées en série avec les via conducteurs 102 et isolées les unes des autres.

L'étape F1 de la figure 4A consiste à déposer sur le substrat 100 une couche électriquement conductrice 300 d'épaisseur h. Cette couche 300 est destinée à former les piliers conducteurs après avoir été gravée.

L'épaisseur h de la couche 300 est avantageusement plus grande que l'épaisseur cumulée des éléments de stockage 120 et des éléments de couverture 130 permettant la prise de contact électrique au-dessus du point mémoire (cf. Fig.1). Ainsi, l'excès de matériau 160 entre les piliers 110 est situé en dessous de l'élément de stockage 120. L'épaisseur h est, de préférence, comprise entre 4 nm et 400 nm. Par exemple, dans les mémoires MRAM à base de jonctions tunnels magnétiques, la jonction tunnel possède une épaisseur de 10 nm à 30 nm et le matériau de couverture peut faire 100 nm d'épaisseur. Dans ce cas, l'épaisseur h est significativement plus grande que 130 nm, et de préférence supérieure à 180 nm.

Par ailleurs, la conductivité électrique du matériau de la couche 300 est telle que, une fois gravée en forme de mesa, la résistance électrique de chaque pilier est faible, typiquement inférieure à la résistance maximale de l'élément de stockage ou point mémoire. On minimise ainsi l'effet de résistance série parasite qui diminue la variation relative de signal au moment de lire l'état du point mémoire (faiblement ou fortement résistif).

A titre d'exemple, le point mémoire est formé par une jonction tunnel magnétique, qui peut être caractérisée d'un point de vue électrique par le produit « Résistance x Aire » ou « RA ». Le produit RA est fonction de l'épaisseur de la barrière tunnel (par exemple, une couche isolante en MgO) et de la hauteur en énergie de cette barrière. Par ailleurs, en faisant l'approximation que la section A d'un pilier est uniforme sur toute sa hauteur h, la résistance électrique $R_t$ du pilier s'écrit :

$$R_t = \frac{\rho.h}{A}$$

où $\rho$ est la résistivité électrique de la couche conductrice 300. Une résistance de pilier Rt bien plus faible que celle de l'élément de stockage constituant le point mémoire équivaut alors à la relation $\rho.h$ << RA, soit $\rho$ << RA/h. Les jonctions tunnel utilisées dans les MRAM à couple de transfert de spin (« Spin Transfer Torque MRAM », STT-MRAM) ont typiquement des valeurs de RA de l'ordre de 10 $\Omega.\mu m^2$. Avec une épaisseur h d'environ 50 nm, cela implique sur la résistivité électrique de la couche 300 la condition suivante : $\rho$ << $2.10^4$ $\mu\Omega$.cm.

Le matériau de la couche conductrice 300 peut être choisi parmi le tantale (Ta), le tungstène (W), l'aluminium (Al), le titane (Ti), le nitrure de titane (TiN) et le silicium polycristallin (poly-Si) fortement dopé (concentration en dopants par exemple supérieure à $5.10^{18}$ cm$^{-3}$ pour un dopage au phosphore). Tous ces matériaux remplissent la condition de résistivité ci-dessus.

Selon une variante de mise en oeuvre, la couche conductrice 300 peut être remplacée par un empilement de plusieurs couches conductrices présentant des caractéristiques similaires à celles décrites précédemment, notamment du point de vue de la résistivité électrique. Un exemple d'empilement avantageux est décrit ci-après, en relation avec la figure 4D.

A l'étape F2 de la figure 4B, un masque de gravure 310 est formé sur la couche conductrice 300. De façon classique, le masque de gravure 310 peut être constitué d'une résine photosensible, structurée par lithographie, ou d'un matériau plus résistant à la gravure que la résine photosensible - on parle dans ce cas de « masque dur ». Le masque dur est, par exemple, en oxyde de silicium (SiO$_2$), en nitrure de silicium (Si$_3$N$_4$), en oxynitrure de silicium (SiON) ou en carbone amorphe.

Les parties pleines du masque 310 constituent des motifs 311 situés à l'aplomb des via conducteurs 102 (ou lignes conductrices) du substrat 100 et ont la forme des éléments de stockage que l'on cherche à réaliser. Avantageusement, chaque motif 311 est centré par rapport au via conducteur 102 sous-jacent et présente des dimensions supérieures à celles du via, de sorte que le pilier formé ultérieurement le recouvre entièrement. Par exemple, les motifs 311 peuvent avoir une largeur L approchant 2F (Fig.4B). Ainsi, lorsque les via 102 sont périodiquement espacés d'une distance égale à 3F, la distance bord à bord des motifs 311 adjacents est de l'ordre de F. La forme des motifs 311 est, de préférence, ronde pour des raisons d'homogénéité des propriétés électriques sur toute la périphérie des piliers et pour faciliter la réalisation du dispositif aux noeuds technologiques les plus avancés (sub-20nm). Néanmoins, d'autres formes peuvent être envisagées, notamment carrée, elliptique et rectangulaire.

En F3 (Fig.4C), la couche conductrice 300 est gravée au travers du masque 310. La technique de gravure utilisée lors de cette étape F3 est, de préférence, une gravure plasma réactive. En effet, celle-ci permet (dans le cas du métal ou du polysilicium de la couche 300) d'obtenir des résidus de gravure volatils qui pourront être éliminés facilement, par pompage hors du réacteur de gravure. Les conditions de gravure sont ici déterminées de sorte à obtenir des piliers conducteurs 110 aux flancs surplombants, par exemple selon un profil à encoche (Fig.1) ou en arc de cercle (Fig.2). Une gravure fortement isotrope devrait être évitée pour empêcher une gravure sous les motifs du masque 310, ce qui réduirait les dimensions de la face supérieure des piliers (et donc des éléments de stockage).

Tous les matériaux susmentionnés peuvent être gravés par un plasma réactif à base de fluor (sauf aluminium) ou de chlore (y compris l'aluminium), voire de brome. Le besoin de réaliser des flancs en retrait requiert une chimie de gravure qui puisse donner lieu à des réactions spontanées entre le matériau et le gaz de gravure. On choisira donc préférentiellement les gaz contenant du chlore, tel que HCl, Cl$_2$ et BCl$_3$, ou du fluor comme SF$_6$, NF$_3$, CF$_4$. Il est également possible d'utiliser des mélanges de gaz à base de chlore et de fluor, ou des mélanges de gaz à base de chlore et de brome (par exemple, HBr est une source de brome)

Pour créer un profil en arc de cercle ou en « tonneau », tout en évitant la sur-gravure sous les motifs 311 du masque 310, les conditions de gravure réactive pourront être choisies comme suit :

- la puissance du champ électromagnétique radiofréquence qui génère le plasma est avantageusement comprise entre 150 W et 500 W, afin de limiter la formation de radicaux à base de chlore ;
- la tension de polarisation appliquée au porte-substrat est, de préférence, comprise entre 15 V et 1 kV, et avantageusement inférieure à 200 V.

Ces paramètres peuvent être ajustés, notamment en cours de gravure, pour contrôler la courbure de l'arc. Par exemple, une augmentation de la puissance RF permet d'augmenter la concentration de radicaux et donc d'augmenter la courbure. Une augmentation de la puissance de polarisation tend à réduire la composante chimique de la gravure et donc à réduire l'amplitude du tonneau. L'ajout d'un gaz diluant (Ar, Xe, He, $N_2$...), pour diminuer la concentration de chlore dans la phase gazeuse, ou l'ajout d'un gaz passivant, tend à rendre le plasma moins réactif et donc à réduire les réactions de gravure spontanées qui créent la courbure des flancs.

Pour créer un profil à encoche, un procédé de gravure en deux ou trois étapes peut être utilisé. Pendant la première étape, on grave la portion supérieure de la couche 300 (typiquement sur 50 % de son épaisseur) de façon anisotrope pour obtenir des flancs verticaux. Ces flancs verticaux sont obtenus grâce à la formation progressive d'une couche de passivation sur les parois des motifs gravés, cette couche de passivation empêchant ensuite la gravure latérale. Pendant la dernière étape, une gravure isotrope est effectuée pour graver la portion restante de la couche 300, verticalement en direction du substrat 100 mais également latéralement. La partie supérieure de la couche 300 est protégée par la couche de passivation formée précédemment lors de la première étape de gravure. Avantageusement, une étape d'oxydation intermédiaire est réalisée pour renforcer la couche de passivation.

A titre d'exemple, un pilier à encoche en polysilicium dopé peut être obtenu grâce à une gravure par plasma à couplage inductif à base de $HBr/Cl_2/O_2$ (110 sccm/70 sccm/2 sccm) avec une énergie des ions comprise entre de 70 eV et 80 eV, suivie d'une gravure par un plasma à base de $Cl_2$ et $SF_6$ (60 sccm/3 sccm) avec une énergie des ions du même ordre de grandeur. Dans le cas d'une couche conductrice 300 en TiN, on peut effectuer la première étape de gravure avec un plasma à couplage inductif à base de $HBr/Cl_2$ (100 sccm/50 sccm), suivie d'une étape intermédiaire de gravure par plasma inductif à base d'$O_2$ pour oxyder les flancs, et enfin une gravure par plasma inductif à base de $Cl_2$ (éventuellement précédée d'un plasma identique avec des ions fortement énergétiques ($\geq$ 50 eV) pour retirer l'oxyde de titane du front de gravure).

Après avoir obtenu des piliers 110 à la forme souhaitée, le masque de gravure 310 peut être éliminé, préférentiellement par voie humide (par exemple dans une solution d'acide fluorhydrique).

Une alternative pour la formation des piliers à encoche est d'employer deux couches superposées de matériaux différents, au lieu d'une seule couche conductrice 300. Le matériau de la couche supérieure est alors gravé de façon anisotrope, alors que le matériau de la couche inférieure est gravé de façon isotrope, sans modifier le profil de la couche supérieure. On peut citer de façon non exhaustive les empilements de couches suivants (couche supérieure/couche inférieure) : Si dopé/Al; Al/Si dopé, Si dopé/TiN, TiN/Al, TiN/W, Al/W, Ru/TiN, Ru/Ti, Ru/Ta, Ru/TaN et Ru/Si dopé.

Par exemple, un empilement Al/W peut être gravé avec un plasma à couplage inductif à base de $BCl_3/Cl_2$ pour l'aluminium puis avec un plasma à couplage inductif à base de $SF_6$ pour le tungstène. Dans le cas d'un empilement Si/TiN, on peut graver le silicium avec un plasma à couplage inductif à base de $HBr/Cl_2/O_2$ puis graver le nitrure de titane avec un plasma à couplage inductif à base de dichlore ($Cl_2$). Le ruthénium d'un empilement Ru/Si peut être gravé par un plasma inductif à base d'oxygène et de dichlore ou de chlorure d'hydrogène (HCl). Un gaz de dilution comme Ar, $H_2$, $N_2$ ou He peut éventuellement être ajouté dans la phase gazeuse du plasma. La puissance RF injectée dans la source est de préférence comprise entre 150 W et 1500 W et la puissance de polarisation peut varier entre 20 W et 300 W, préférentiellement entre 20 W et 50 W, afin de ne pas trop consommer le masque dur et la couche de silicium dopé sous-jacente à la fin de la gravure du ruthénium. La couche de silicium peut alors être gravée à l'aide d'un plasma inductif à base de $SF_6$ ou de $NF_3$, éventuellement dilué par de l'argon ou de l'hélium.

Dans un mode de mise en oeuvre préférentiel représenté par la figure 4D, le procédé comprend en outre une étape F4 de formation de la couche isolante 200 sur les flancs des piliers 110. Comme cela a été décrit précédemment, cette étape est recommandée afin d'éviter les courts-circuits entre les piliers conducteurs 110, tout en limitant les contraintes sur les dimensions des piliers et le choix du matériau diélectrique séparant les piliers.

La couche isolante 200 peut être obtenue de différentes manières. Une première technique consiste à former contre les parois latérales des piliers 110 des espaceurs diélectriques identiques ou similaires à ceux utilisés dans les structures de grille des transistors MOS. Ces espaceurs sont, de préférence, formés par dépôt de couches atomiques (« Atomic Layer Deposition », ALD). Cette technique de l'industrie microélectronique présente l'avantage de pouvoir réaliser des dépôts conformes, même ici sur des flancs en forme de tonneaux ou à encoche. Les matériaux possibles sont par exemple $Si_3N_4$, $HfO_2$, $ZrO_2$ ou encore $Al_2O_3$.

Après dépôt des espaceurs dont l'épaisseur peut être comprise entre 2 nm et 5 nm, une étape de gravure permet d'éliminer le matériau de l'espaceur aux sommets des piliers 110. On choisira préférentiellement des procédés de gravure sélectifs vis-vis du matériau constituant les piliers 110. Il convient en effet de minimiser l'endommagement de leur face supérieure, qui recevra un élément de stockage de résistance électrique variable. Il est également possible d'utiliser un matériau sacrificiel (tel que $SiO_2$ ou $Si_3N_4$) dont la nature chimique est différente de celle de l'espaceur, pour protéger cette surface pendant la gravure de l'espaceur. Le masque dur 310 peut d'ailleurs jouer ce rôle protecteur, auquel cas il n'est retiré qu'après avoir formé la couche isolante 200, et non pas avant.

Selon une variante de mise en oeuvre, la couche isolante 200 est obtenue par oxydation ou nitruration du matériau qui constitue les piliers 110. Autrement dit, on peut rendre les flancs des piliers isolants du point de vue électrique en les exposant à de l'oxygène ou à de l'azote. Un plasma d'oxygène ou d'azote peut être utilisé pour rendre cette oxydation ou nitruration plus efficace. Dans le même but, le substrat peut être chauffé entre 20 °C et 450 °C.

Pendant cette étape d'oxydation/nitruration, la face supérieure des piliers 110 est également affectée si elle n'est pas protégée. Ainsi, pour éviter la formation d'un matériau isolant sur cette face supérieure, ce qui conduirait à des problèmes de lecture/écriture du point mémoire, on peut comme précédemment conserver le masque de gravure 310 lors de l'étape d'oxydation/nitruration et ne le retirer qu'après, ou déposer un autre matériau protecteur dit sacrificiel, tel qu'un nitrure de silicium (SiN, $Si_3N_4$, SiOCN, SiNH) ou un oxyde de silicium ($SiO_2$). Le matériau protecteur est ultérieurement retiré pour rendre à nouveau conductrice la face supérieure des piliers 110. Bien entendu, le procédé de retrait est choisi de sorte qu'il n'affecte par la couche isolante 200 qui vient d'être formée sur les flancs des piliers 110. Par exemple, dans le cas d'un tantale nitruré sur les flancs, une couche sacrificielle en $SiO_2$ sur la face supérieure peut être éliminée par une solution d'acide fluorhydrique.

Une alternative est l'utilisation d'un empilement de plusieurs sous-couches au lieu d'une seule couche 300. Comme précisé à l'étape F1, la couche 300 peut être remplacée par deux matériaux, préférentiellement deux métaux, ayant des propriétés différentes. Deux cas de figure se présentent :

- le matériau supérieur dit protecteur est insensible à l'oxydation ou à la nitruration - il s'agit par exemple d'un métal noble - et le matériau inférieur qui forme les piliers 110 est susceptible de former un oxyde ou un nitrure (Ta, W, Al, Ti, TiN, Si...). De cette manière, le matériau supérieur sera conducteur alors que les flancs du matériau inférieur seront isolants. La gravure du métal noble, à l'étape F3, peut nécessiter une autre technique de gravure que celle utilisée pour le matériau des piliers 110, par exemple la gravure par faisceau d'ions (« Ion Beam Etchnig », IBE).
- les matériaux inférieur et supérieur sont tous deux susceptibles de former un oxyde ou un nitrure, mais ces derniers ont des comportements électriques différents : l'oxyde/nitrure du matériau supérieur est conducteur et l'oxyde/nitrure du matériau inférieur est isolant. A titre d'exemple, on peut utiliser comme matériau supérieur le ruthénium (Ru) ou le chrome (Cr) dont les oxydes sont conducteurs, ou le titane (Ti) dont le nitrure est conducteur, en combinaison avec du Ti, TiN, Ta, Si, Al ou W dont l'oxyde est isolant, ou avec du Si ou Ta dont le nitrure est isolant.

Bien sûr, lorsque la technique des espaceurs est employée pour former la couche isolante 200, il n'est pas nécessaire d'avoir recours à une couche de protection en chrome, ruthénium ou en métal noble.

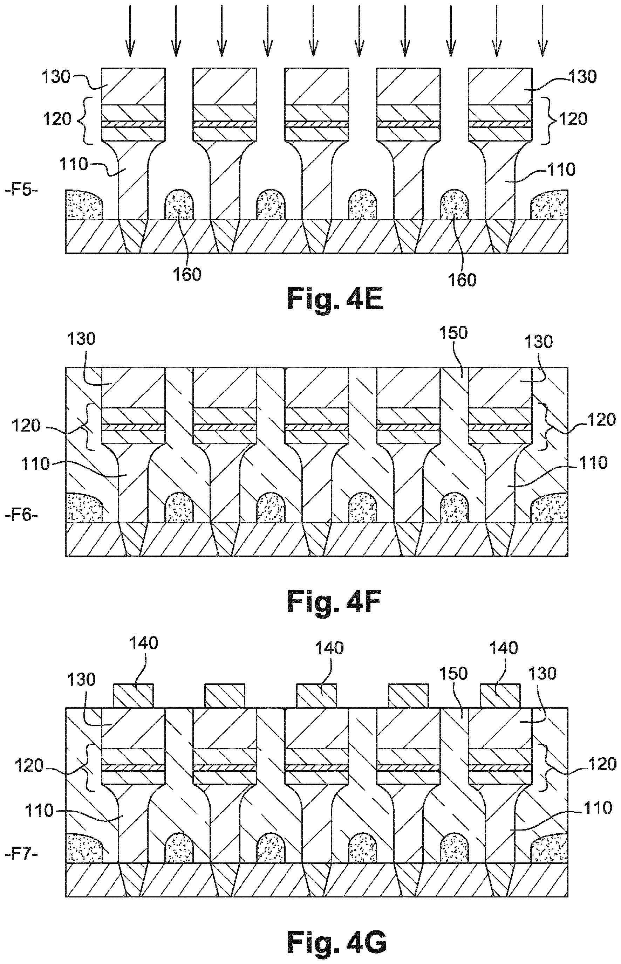

La figure 4E représente schématiquement une étape F5 dans laquelle on dépose, dans un premier temps, le matériau résistif des éléments de stockage aux sommets des piliers 110, et dans un deuxième temps, le matériau des éléments de couverture 130 permettant la prise de contact électrique.

La pulvérisation cathodique est avantageusement utilisée à l'étape de dépôt F5. Cette technique présente une certaine directivité permettant de diriger le dépôt de matériau résistif vers les piliers 110, notamment à leur sommet. Toutefois, du matériau résistif et du matériau de couverture se déposent également au fond des tranchées situées entre les piliers 110, voire sur une partie des flancs des piliers suivant l'incidence du dépôt et la dispersion angulaire du flux d'atomes issus de la cible pulvérisée, formant alors des dépôts résiduels 160. En incidence normale par rapport à la surface du substrat (cas représenté sur la figure 4E), ces dépôts résiduels 160 sont localisés autour du centre des tranchées. Plus les flancs des piliers 110 sont surplombants, moins les dépôts 160 s'étalent à proximité de la base des flancs. En incidence oblique (cas non représenté), les dépôts 160 peuvent être situés d'un seul et même côté des piliers 110, voire sur tous les côtés des piliers si le substrat est entraîné en rotation pendant le dépôt.

La formation de flancs en retrait empêche donc le dépôt simultané de matériau résistif sur deux flancs se faisant face et appartenant à des piliers différents, ce qui évite un court-circuit entre ces deux piliers. De préférence, la pulvérisation cathodique est collimatée afin d'augmenter la directivité du dépôt et donc diminuer l'étendue des dépôts résiduels 160 au fond des tranchées. Les dépôts 160 peuvent être laissés tels quels. Grace à la discontinuité électrique sur les flancs des piliers 110, ils ne perturbent pas de façon significative le fonctionnement du dispositif résistif. En particulier, ils ne créent pas de courts-circuits inter-plots.

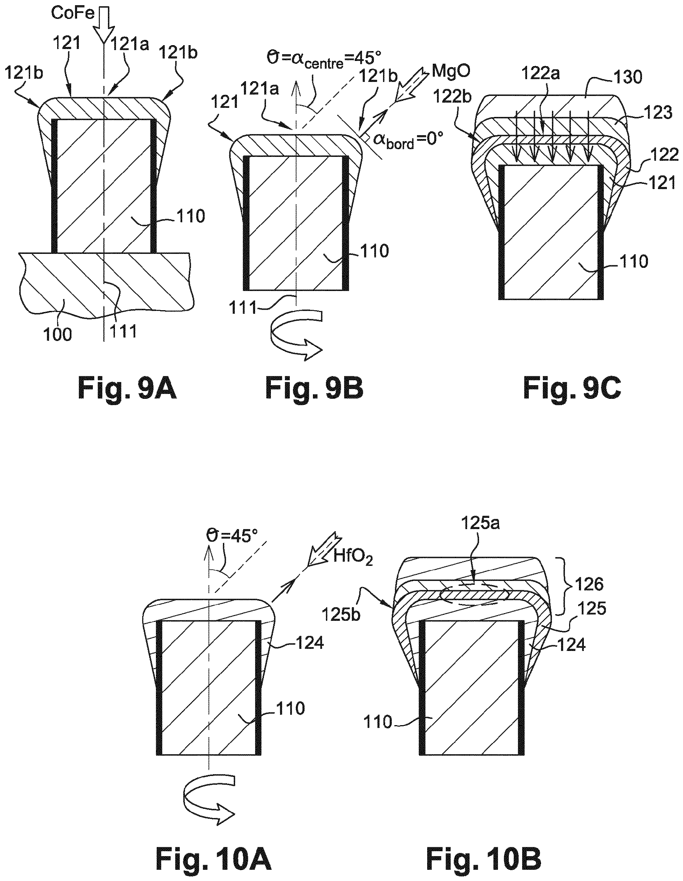

La formation des éléments de stockage 120 aux sommets des piliers 110 peut comprendre le dépôt d'un ou plusieurs matériaux, suivant la technologie de mémoires ou d'éléments logiques envisagée. Par exemple, pour fabriquer une jonction tunnel magnétique de mémoire MRAM, on dépose successivement une couche de référence (ex. un alliage à base de Co, Fe et B), une couche de barrière tunnel (ex. MgO) et une couche de stockage (ex. un alliage à base de Co, Fe et B, avec des concentrations identiques ou différentes de celles de la couche de référence). La couche de référence et la couche de stockage sont (ferro)magnétiques, tandis que la couche de barrière tunnel est non-magnétique. La couche de stockage peut être située au-dessus ou en-dessous de la barrière tunnel, la couche de référence étant située de l'autre côté de la barrière tunnel par rapport à la couche de stockage. La jonction tunnel est généralement recouverte par l'élément de couverture 130. Les différentes couches des éléments de stockage 120 peuvent être déposées par des techniques différentes et suivant des incidences différentes (cf. Figs.9 à 12). Pour une mémoire PCRAM et une mémoire ReRAM (OxRAM, CBRAM), le matériau déposé est respectivement un matériau à changement de phase et un oxyde résistif inséré entre des électrodes conductrices.

Dans le cas des MRAM, on cherche généralement à maximiser la surface de la jonction tunnel magnétique (pour une densité de mémoire donnée), dans le but d'améliorer la stabilité thermique de l'aimantation de la couche de stockage. En effet, dans les MRAM de dimensions suffisamment faibles pour avoir un comportement de type macrospin (typiquement en dessous de 40 nm de dimension latérale), le facteur de stabilité thermique de la mémoire varie de façon sensiblement proportionnelle à sa surface. Le fait de disposer de piliers évasés, avec une section au sommet plus grande qu'à leur base, permet de maximiser la surface de l'élément magnétique pour une surface totale donnée par point mémoire et ainsi de maximiser la stabilité thermique de l'aimantation de la couche de stockage. On veillera toutefois à ce que les interactions magnétostatiques de plot à plot ne deviennent pas trop fortes, du fait de la proximité des bords de jonctions voisines.

L'étape F6 représentée par la figure 4F consiste à remplir d'un matériau électriquement isolant 150 l'espace entre les structures verticales formées par les piliers 110, éléments de stockage 120 et éléments de couverture 130 superposés. Diverses techniques de l'industrie microélectronique permettent de remplir de matériau diélectrique (généralement un oxyde) des structures à facteur de forme élevé (type STI, FinFET, transistor à grille « damascène »...) et/ou avec des flancs surplombants. On peut citer notamment le dépôt en phase gazeuse de films diélectriques liquides. Les diélectriques liquides sont semblables à un gel ayant les caractéristiques d'écoulement d'un liquide. En exploitant cette technique, on peut aisément remplir des structures avec des facteurs de forme supérieurs à 10, allant même jusqu'à 30.

Le matériau diélectrique liquide pour le remplissage des tranchées inter-plots de la figure 4F peut être choisi parmi $Si_3N_4$, $SiO_2$, $SiO_xC_yH_z$, $SiO_xH_y$ et $SiO_xN_yH_z$. Ces matériaux sont choisis pour leur résistivité électrique (avantageusement $\rho > 0.1$ $\Omega$.cm) afin que les courants de fuite entre points mémoire soient minimisés. Par exemple, pour former un oxyde de silicium liquide, le substrat est exposé simultanément à un précurseur gazeux contenant du silicium et à un gaz oxydant. Le gaz contenant le silicium et le gaz oxydant sont, soit mélangés avant leur introduction dans le réacteur, soit injectés séparément dans le réacteur. Le précurseur contenant du silicium peut être un alkoxysilane, par exemple $H_x$-Si-$(OR)_y$ où x=0-3, x+y=4 et R désigne un groupe alkyl. Le silane ($SiH_4$) et ses dérivés, tels que le tetraethoxysilane (TEOS), le triéthoxysilane (TES), le triméthoxysilane (TriMOS), le méthyltriméthoxysilane (MTMOS), le diméthyldiméthoxysilane (DMDMOS), le diéthoxysilane (DES), le diméthoxysilane (DMOS), l'héxaméthoxydisilane (HMODS) et le triphényléthoxysilane, ou bien encore le tétraoxyméthylcyclotétrasiloxane (TOMCTS), l'octaméthylcyclotétrasiloxane (OMCTS), le méthyltriéthoxyorthosilicate (MTEOS), le tétraméthylorthosilicate (TMOS), le 1-(triéthoxysilyl)-2-(diéthoxyméthylsilyl)éthane et le tri-t-butoxylsilanol sont d'autres exemples de précurseurs contenant du silicium. Le gaz oxydant peut être l'ozone ($O_3$), le péroxyde d'hydrogène ($H_2O_2$), l'oxygène ($O_2$), l'eau ($H_2O$), le méthanol, l'éthanol, l'isopropanol ou un oxyde nitrique (NO, $N_2O$). La température du substrat et la pression de travail dans le réacteur permettent d'ajuster les vitesses de dépôt. Généralement, la température du substrat est comprise entre -30 °C et 100 °C (une température faible permet d'augmenter la vitesse de dépôt). La pression est par exemple comprise entre 100 mT et la pression atmosphérique.

L'avantage de cette technique par rapport aux autres techniques de dépôt en phase gazeuse est l'absence de vides ou cavités dans la couche de matériau diélectrique 150. Néanmoins, la présence de vides dans l'espace inter-plots n'est pas préjudiciable, tant qu'une surface plane et continue est obtenue à l'issue de l'étape F6. La présence de vides entre les plots peut même présenter des avantages dans certaines situations. Par exemple, dans le cas des PCRAM, ces vides peuvent diminuer les phénomènes de diaphonie (« crosstalk ») entre les piliers, en limitant la diffusion thermique latérale. En contrepartie, les structures verticales peuvent être plus fragiles. Les techniques de dépôt physique en phase vapeur (PVD), de dépôt chimique en phase vapeur assisté par plasma (PECVD), de dépôt de couches atomiques (ALD) forment des couches d'épaisseur uniforme et sont donc susceptibles de former des vides dans les structures à fort facteur de forme, a fortiori lorsqu'elles ont des flancs en retrait (car elles conduisent rapidement à un pincement au sommet de la structure).

Une alternative aux procédés en phase gazeuse est le dépôt par centrifugation. Dans ce cas, un précurseur sol-gel est dilué dans un solvant et déposé sous forme liquide sur le substrat en rotation. Sous l'effet de la force centrifuge, le liquide se répartit de façon uniforme à la surface du substrat. Les précurseurs polymérisent et le solvant s'évapore pour former un matériau diélectrique appelé « Spin On Glass » (SOG). L'épaisseur de la couche déposée est contrôlée par la viscosité du matériau et la vitesse de rotation du substrat. Les matériaux ainsi réalisés peuvent être des silices ou des silicones de type poly-méthylsiloxane, poly-métylsilsesquioxane, poly-oxycarbosilane, poly-dimétylsiloxane. Ils peuvent aussi être des polymères, tels que des résines planarisantes, par exemple celle commercialisée par la société « Honeywell » sous la dénomination « ACCUFLO ».

Avantageusement, une couche barrière (ex. $Si_3N_4$) peut être déposée sur les structures verticales préalablement au remplissage par le matériau diélectrique 150, afin d'éviter le contact de ces structures avec l'environnement oxydant. La couche barrière a de préférence une épaisseur comprise entre de 3 nm et 5 nm. Elle permet de bloquer la diffusion des espèces oxydantes, sans que les dimensions des motifs ne soient trop impactées. Un procédé de type ALD ou PEALD est préféré pour garantir une couverture totale des surfaces, y compris les flancs en retrait.

Un remplissage partiel des tranchées est envisageable, dans la mesure où l'isolation électrique est assurée même en présence de vides. Cela peut permettre de réduire la conductance inter-plots et donc de minimiser les risques de diaphonie entre les plots.

Avec toutes les techniques de dépôt susmentionnées, il est difficile d'obtenir directement une surface plane au niveau de la face supérieure des éléments de couverture 130. Par conséquent, il est préférable de recouvrir entièrement les structures verticales avec le matériau diélectrique et d'éliminer ensuite le matériau en excès. Pour ce faire, on peut utiliser une méthode de planarisation mécano-chimique ou une gravure plasma de type « etch back » (typiquement $CF_4$, $CHF_3$, $CH_2F_2$, $C_4F_8$ ou $C_4F_6$) lorsque le dépôt du matériau diélectrique tend déjà à produire une couche plane. De façon classique, le procédé de polissage ou de gravure plasma est stoppé lorsque le matériau de couverture 130 est atteint. Ceci peut être réalisé en contrôlant les conditions de polissage/gravure, connaissant la vitesse de gravure et l'épaisseur du matériau à graver, ou en détectant la fin de gravure pendant le procédé (par exemple par réflectométrie ou spectroscopie d'émission optique).

Enfin, à l'étape F7 de la figure 4G, un niveau de contact ou de métallisation est formé sur la surface plane obtenue à l'issue de l'étape F6. Chaque contact électrique 140 est placé au sommet d'une structure verticale sur l'élément de couverture 130, et de préférence au centre de celui-ci. Les contacts 140 sont obtenus de façon classique grâce à un procédé dit « cloisonné » (dépôt d'une couche de matériau conducteur, structuration par photolithographie puis gravure), par un procédé de type « damascène » ou par un procédé de soulèvement (« lift-off » en anglais).

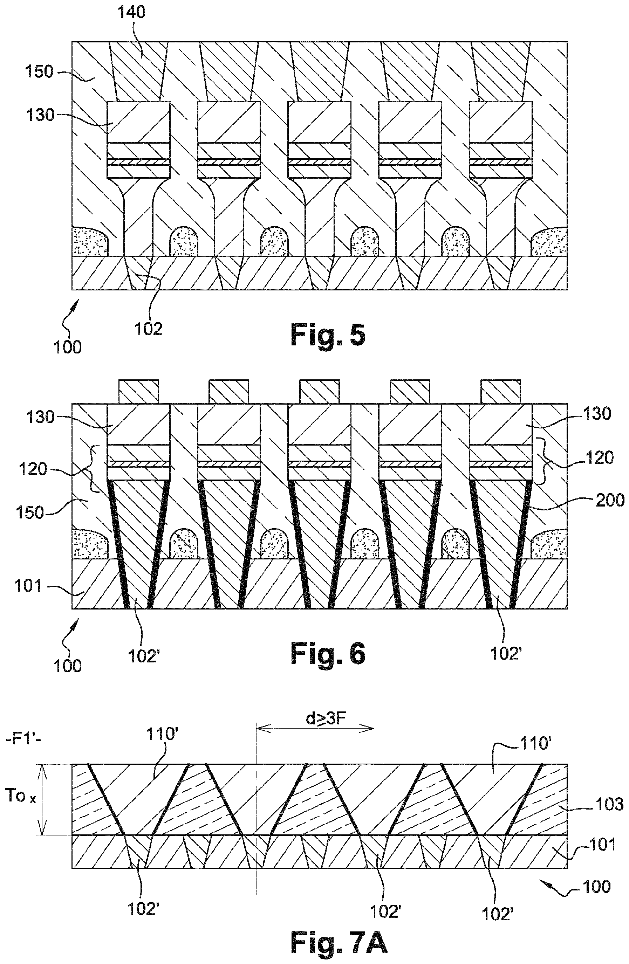

Selon une variante de mise en oeuvre des étapes F6 et F7 représentée par la figure 5, le matériau diélectrique de remplissage 150 est déposé sur le substrat 100 jusqu'à recouvrir entièrement les structures verticales. Puis, les contacts 140 sont formés selon une approche « damascène » au sein même du matériau 150. On ouvre dans le matériau 150 des cavités qui débouchent sur les éléments de couverture 130, puis on remplit ces cavités de métal (typiquement du cuivre ou de l'aluminium) et enfin on élimine le métal en excès par CMP. Ainsi, dans cette variante de mise en oeuvre, les contacts électriques 140 sont compris dans la couche de remplissage en matériau diélectrique 150, et non dans une couche diélectrique additionnelle déposée sur la couche de remplissage. L'étape de planarisation (par CMP ou gravure plasma), décrite en relation avec la figure 4F et permettant à la couche de remplissage 150 d'affleurer au niveau des éléments de couverture 130, peut alors être supprimée.

On constate sur la vue de coupe de la figure 5 que, lorsqu'ils sont réalisés selon le procédé « damascène », les contacts électriques 140 et les via conducteurs 102 du substrat 100 ont eux aussi une forme évasée, avec une section à la base plus petite qu'à leur sommet. De par leur forme, les via conducteurs de type damascène pourraient donc servir de support aux éléments de stockage de résistance variable. Ainsi, dans un troisième mode de réalisation du dispositif résistif, les piliers conducteurs évasés sont constitués par des via d'interconnexion électrique de type damascène.

Sur la figure 6, les piliers sont avantageusement formés par la partie supérieure de via conducteurs 102' appartenant au dernier niveau d'interconnexion du substrat 100 (avant les points mémoire). Autrement dit, les via conducteurs 102' sont prolongés en dehors de la couche diélectrique 101 et servent de support au dépôt des éléments de stockage 120 et des éléments de couverture 130, avant d'être entourés par le matériau diélectrique de remplissage 150.

Alternativement, les piliers conducteurs peuvent être formés par des via d'interconnexion de type damascène distincts des via d'interconnexion 102 de la couche diélectrique 101. Les figures 7A à 7C représentent des étapes F1' à F3' d'un procédé permettant de fabriquer cette dernière variante de réalisation du dispositif résistif.

A l'étape F1' de la figure 7A, des structures verticales d'interconnexion 110' de type damascène sont formées dans une couche diélectrique additionnelle 103 disposée sur le substrat 100, et plus particulièrement sur la couche diélectrique 101 contenant les via d'interconnexion 102. D'abord, la couche diélectrique 103 d'épaisseur $t_{ox}$ est déposée sur le substrat 100. L'épaisseur $t_{ox}$ est, de préférence, comprise entre 4 nm et 400 nm. Puis, des cavités sont gravées dans la couche diélectrique 103 jusqu'au substrat 100, de préférence par un procédé de gravure plasma. Des cavités aux flancs légèrement obliques (ce profil facilite l'étape de métallisation) peuvent être obtenues par un plasma à base de gaz fluorocarboné ($C_xH_yF_z$) éventuellement dilué dans $N_2$ et/ou Ar. Des couches fluorocarbonées se forment alors sur les flancs des motifs gravés. Enfin, un matériau conducteur est déposé sur la couche diélectrique de façon à remplir entièrement les cavités et l'excès de matériau conducteur en dehors des cavités est supprimé par polissage mécano-chimique (CMP).

Les structures d'interconnexion 110' peuvent être obtenues par un procédé « simple damascène » ou « double damascène ». Dans le procédé « simple damascène », un seul motif (ex. via ou ligne) est formé puis rempli de métal dans la couche diélectrique 103, alors que le procédé « double damascène » remplit simultanément deux motifs superposés, par exemple un via d'interconnexion et une ligne d'interconnexion recouvrant le via.

Les structures d'interconnexion 110' sont situées aux emplacements où un point mémoire est souhaité, en contact avec les via d'interconnexion 102 du substrat 100. Ensemble, ils conduisent le courant électrique entre les points mémoire et le circuit de lecture situé dans le substrat 100. La distance entre deux structures d'interconnexion 110' consécutives est, de préférence, égale ou supérieure à 3F, où F est la plus petite dimension atteignable par photolithographie.

De préférence, le matériau conducteur des structures d'interconnexion 110' est choisi parmi le cuivre, le tantale, le tungstène, le nitrure de titane et l'aluminium, ou une combinaison de ces matériaux (par exemple du Cu entouré de TiN), en raison de leur résistivité électrique faible ($\rho << 10^4 \mu\Omega.cm$). La couche diélectrique additionnelle 103 peut être constituée d'un oxyde de silicium ($SiO_2$, SiOCH), un nitrure de silicium ($Si_3N_4$, SiCN) ou un matériau polymère isolant (ex. matériaux commercialisés par la société « Dow chemical » sous la dénomination « SiLK » et par la société « Honeywell » sous la dénomination « FLARE »). Elle peut aussi être composée de deux matériaux isolants différents, formant ainsi deux sous-couches, par exemple une sous-couche inférieure en SiCN et une sous-couche supérieure en $SiO_2$. La sous-couche inférieure joue avantageusement le rôle de barrière à la diffusion du métal constituant les structures d'interconnexion 110' (et autres motifs d'interconnexion formés simultanément, type via ou ligne) vers le substrat.

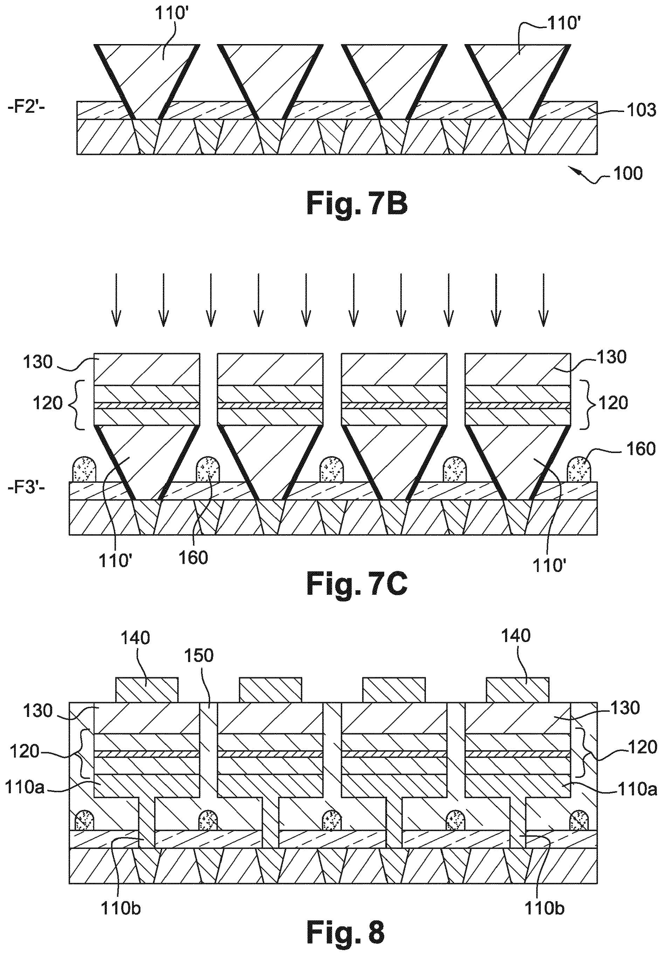

L'étape F2' de la figure 7B consiste à amincir la couche diélectrique 103, de sorte à libérer partiellement les structures d'interconnexion 110'. On obtient alors des piliers de forme évasée qui se dressent verticalement sur le substrat 100. Leur sommet est libre, tandis que leur base est enterrée dans la couche diélectrique 103, ce qui améliore leur maintien et assure le contact électrique avec les vias sous-jacents.

Avantageusement, l'épaisseur de matériau retiré à l'étape F2' (soit la hauteur des piliers mesurée depuis la face supérieure de la couche diélectrique 103 restante jusqu'aux sommets) est bien supérieure à l'épaisseur cumulée des éléments de stockage et de couverture qui seront déposés par la suite, par exemple 1,2 fois l'épaisseur cumulée des éléments de stockage et de couverture.

Dans une variante de mise en oeuvre, la couche diélectrique 103 est retirée entièrement. Les piliers tiennent debout sur le substrat 100, même en l'absence de la couche 103 (puis l'ensemble de la structure sera consolidé par le matériau diélectrique de remplissage 150).

Le retrait du matériau diélectrique 103 est, de préférence, réalisé par une gravure isotrope et sélective par rapport au matériau conducteur des structures d'interconnexion 110', afin de libérer les flancs des piliers sur toute l'épaisseur gravée et de ne pas augmenter la rugosité de surface, en particulier sur leur face supérieure destinée à recevoir un élément de stockage. A titre d'exemple, dans le cas d'un isolant de type $SiO_2$, l'étape de retrait peut être réalisée par voie humide, au moyen d'une solution d'acide fluorhydrique ou d'acide fluorhydrique en phase vapeur. Pour un matériau à base de carbone, un plasma réactif à base d'oxygène peut être utilisé. La combinaison d'un plasma d'oxygène et d'une attaque chimique en acide fluorhydrique permet de graver un matériau poreux de type SiOCH. Enfin, dans le cas où la couche diélectrique additionnelle 103 contenant les structures d'interconnexion 110' est composée de deux matériaux distincts, l'étape d'amincissement F2' peut être réalisée en gravant en totalité la sous-couche supérieure, alors que la sous-couche inférieure sert de couche d'arrêt à cette gravure. L'épaisseur de matériau diélectrique retiré peut être contrôlée par le temps de gravure, connaissant la vitesse de gravure (sauf dans le cas d'une sous-couche d'arrêt sélective, où un tel contrôle n'est pas nécessaire).

La figure 7C représente l'étape F3' de dépôt PVD des éléments de stockage 120 et des éléments de couverture 130 aux sommets des structures d'interconnexion 110'. L'étape F3' est identique à l'étape F5 décrite précédemment en relation avec la figure 4E, bien que les piliers n'aient pas été obtenus de la même manière. A l'issue de l'étape F3', des dépôts résiduels 160 sont situés sur la couche diélectrique amincie 130, entre les structures d'interconnexion 110'. Ces dépôts résiduels 160 ne perturbent pas le fonctionnement du dispositif.

Les étapes F6 et F7 du procédé de fabrication des figures 4A à 4G (remplissage par le matériau diélectrique et formation des contacts électriques), ainsi que leur variante représentée par la figure 5, peuvent être réalisées à l'issue de l'étape de dépôt F3', selon les mêmes modes opératoires.

Si l'on souhaite former des piliers conformément à l'exemple de réalisation de la figure 6, c'est-à-dire en réutilisant les via conducteurs 102 plutôt qu'en créant un niveau d'interconnexion supplémentaire, seule la couche diélectrique 101 est utilisée. L'étape F1' comprend alors la formation des via conducteurs 102 de type damascène dans la couche diélectrique 101 et, à l'étape F2', la couche diélectrique 101 est amincie pour libérer les piliers conducteurs. Il n'y a donc pas de couche diélectrique additionnelle 103 dans ce mode de réalisation et le dernier niveau d'interconnexion du substrat 100 avant les points mémoire est dimensionné pour former les piliers.

Pour isoler électriquement les flancs des piliers dans ce troisième mode de réalisation, une couche en matériau isolant ($Si_3N_4$, $HfO_2$, SiOCH...) peut être déposée dans les cavités lors de la formation des structures d'interconnexion de type damascène. Ce dépôt a lieu avant le remplissage par le matériau conducteur. Un procédé de type CVD, PECVD, ALD ou PECVD est avantageusement utilisé, afin que la couche isolante épouse parfaitement les parois latérales des cavités et les recouvre de façon homogène. Cette couche, ou revêtement (« liner » en anglais), a de préférence une épaisseur comprise entre 2 nm et 5 nm, afin d'éviter une augmentation trop importante de la résistivité des piliers tout en isolant correctement leurs flancs. Si besoin, le matériau isolant déposé sur la face supérieure de la couche diélectrique 103 pourra être éliminé pendant l'étape de planarisation ayant lieu après le remplissage par le métal. Enfin, pour rétablir la continuité électrique, le matériau isolant déposé au fond des cavités peut être supprimé par un procédé de pulvérisation par bombardement ionique (typiquement un plasma d'argon).

En plus de sa fonction d'isolation électrique, le revêtement sur les parois latérales des cavités peut servir de couche barrière, en empêchant la diffusion du métal dans le matériau diélectrique.

Au moment de former les structures d'interconnexion 110' (étape F1'), d'autres motifs d'interconnexion (via ou lignes) peuvent être formés simultanément dans une autre portion du substrat, par exemple pour prendre contact avec les zones de source, de drain et de grille des transistors de sélection. Une couche en matériau sacrificiel (ex. SiCN, $Si_3N_4$) est d'abord déposée sur le substrat après l'étape F1'. Puis, celle-ci est ouverte dans la portion où l'on souhaite former les points mémoire. Après dépôt du matériau résistif et du matériau de couverture, la couche sacrificielle est retirée par gravure isotrope, emportant avec elle les matériaux qui la recouvrent (par soulèvement). Avantageusement, une barrière diélectrique est déposée sur les motifs d'interconnexion et les points mémoire, avant le remplissage des tranchées par le matériau diélectrique 150 et la formation des contacts électriques 140.

La figure 8 représente la configuration des structures d'interconnexion 110' lorsqu'elles sont formées selon un procédé « double damascène ». Les structures 110' sont en deux parties, une partie supérieure 110a et une partie inférieure 110b. Les parties 110a et 110b ont chacune une section constante. Toutefois, la section de la partie supérieure 110a est plus grande que celle de la partie inférieure 110b, d'où il résulte un décrochement. Ce décrochement favorise la discontinuité du dépôt de matériau résistif et du matériau de couverture à l'étape F3'. La partie supérieure 110a formée par une ligne peut être gravée dans la couche diélectrique avant la partie inférieure 110b formée par un via (« approche « Trench First Via Last ») ou bien après (« approche « Via First Trench Last »).

Dans la technique de pulvérisation cathodique utilisée à l'étape F5 (Fig.4E) pour déposer les éléments de stockage aux sommets des piliers 110, une cible constituée du matériau à déposer est bombardée par un plasma, généralement à base d'argon. A moins que des diaphragmes soient interposés entre cette cible et le substrat lors du dépôt, les espèces chimiques sont émises depuis la cible avec une certaine distribution angulaire. L'angle d'ouverture de cette distribution dépend notamment du mode de pulvérisation (continu ou radiofréquence), de la tension appliquée à la cible, de la pression du gaz de pulvérisation et de la nature du matériau pulvérisé. Typiquement, cet angle d'ouverture mesure entre -20° à +20° par rapport à une direction normale à la cible (mesure à mi-hauteur). Les diaphragmes permettent d'augmenter la directivité du faisceau d'espèces pulvérisées, en limitant l'ouverture angulaire. On parle dans ce cas de pulvérisation cathodique collimatée.

Lorsque la pulvérisation cathodique de l'étape F5 n'est pas collimatée, la couche déposée au sommet de chaque pilier présente une forme arrondie aux bords du pilier, plutôt qu'en angle droit (cf. Fig.4E), du fait de la dispersion angulaire du faisceau d'espèces pulvérisées. Cette forme arrondie résulte d'un effet d'ombrage se produisant lors du dépôt au niveau de chaque pilier. Ici, on propose de mettre à profit cette forme arrondie aux bords des piliers afin de créer dans les éléments de stockage des variations locales d'épaisseur et/ou de composition chimique. Cela permet notamment de confiner le courant électrique dans la partie centrale de chaque point mémoire, loin des bords où le risque de rencontrer des défauts structurels est le plus grand (mais néanmoins moindre par rapport aux procédés de gravure plasma et IBE de l'art antérieur). Les gradients d'épaisseur et de composition sont avantageusement créés en jouant sur l'incidence du dépôt par pulvérisation cathodique. Divers exemples d'éléments de stockage mettant en oeuvre ce principe sont décrits ci-après.

Les figures 9A à 9C représentent en détail la formation d'une jonction tunnel magnétique de mémoire MRAM au sommet d'un pilier 110. L'empilement de couches qui constitue la jonction tunnel magnétique comprend par exemple une électrode inférieure contenant la couche magnétique de référence 121 en alliage CoFeB, une couche de barrière tunnel 122 en MgO et une couche magnétique de stockage 123 en alliage CoFeB. Un élément de couverture 130, par exemple en tantale, est ajouté pardessus l'empilement en vue de la prise de contact électrique supérieur.

Sur la figure 9A, l'électrode inférieure contenant la couche de référence 121 en CoFeB est déposée par pulvérisation cathodique non collimatée selon une incidence normale au plan du substrat 100, soit parallèlement à l'axe de symétrie 111 du pilier 110 (ce dernier étant orienté perpendiculairement au substrat 100). La couche 121 comprend alors une portion plane 121a au centre de la face supérieure du pilier 110 et des bords 121b de forme arrondie recouvrant partiellement les flancs du pilier 110.

On procède ensuite au dépôt de la couche de barrière tunnel 122 en MgO sur la couche de référence 121 (Fig.9B). Le dépôt de MgO est avantageusement réalisé par pulvérisation cathodique en incidence oblique selon un angle $\theta$ mesuré par rapport à l'axe 111 du pilier 110, par exemple égal à 45°. Il en résulte que le matériau se dépose plus lentement sur la portion centrale 121a de la couche 121 que sur le bord arrondi 121b disposé du même côté que la source de MgO (bord de droite sur la figure 9B). En effet, en pulvérisation cathodique, la vitesse de dépôt est proportionnelle au cosinus de l'angle $\alpha$ entre la normale à la surface sur laquelle se dépose le flux de matériau et la direction de propagation de ce flux. Or, l'angle $\alpha$ vaut 45° au niveau de la portion plane 121a ($\alpha_{centre} = \theta = 45°$), tandis qu'en s'approchant du bord arrondi 121b, l'angle $\alpha$ diminue pour atteindre 0° au mi-

lieu de l'arrondi ($\alpha_{bord}$ = 0°).

Lors du dépôt, le substrat qui supporte le pilier 110 est avantageusement entraîné en rotation. Cela permet d'obtenir une couche de barrière tunnel 122 symétrique ayant une portion centrale 122a plus fine que ses bords 122b (car la vitesse de dépôt y est plus faible), comme illustré à la figure 9C.

La formation de la jonction tunnel s'achève par le dépôt de la couche de stockage 123 en CoFeB sur la couche de barrière tunnel 122, puis l'élément de couverture 130 en tantale est déposé sur la couche de stockage 123. Ces deux dépôts sont, de préférence, réalisés par pulvérisation cathodique collimatée selon une incidence normale, afin d'éviter que les couches 123 et 130 ne débordent sur les flancs du pilier 110 (ce qui pourrait occasionner un court-circuit de la jonction tunnel magnétique).

Ainsi, un gradient latéral d'épaisseur de la couche de barrière tunnel 122 en MgO peut être obtenu en jouant sur l'incidence du dépôt. Ce gradient est particulièrement avantageux lors du fonctionnement de la mémoire MRAM. En effet, lorsqu'une tension est appliquée de part et d'autre de la jonction tunnel magnétique, le courant électrique circule à travers la couche de barrière tunnel 122 et préférentiellement au centre de celle-ci, c'est-à-dire dans la portion 122a où son épaisseur est la plus faible (Fig.9C). Ainsi, on peut réduire l'impact d'éventuels défauts de bord sur les propriétés électriques et magnétiques des points mémoire et ainsi réduire la variabilité d'un point mémoire à l'autre dans une mémoire MRAM.

Les figures 10A et 10B représentent un autre exemple d'obtention d'un gradient latéral d'épaisseur, cette fois dans un élément de stockage de type OxRAM. Dans ce type de point mémoire, on forme de façon réversible un chemin conducteur à travers un oxyde, par accumulation de lacunes d'oxygène. L'empilement type comprend une première électrode 124 (par exemple en TiN), une couche d'oxyde 125 (ex. $HfO_2$) et une deuxième électrode 126 (ex. Ti/TiN).

A nouveau, pour minimiser la variabilité d'un point mémoire à l'autre, il est avantageux de conformer le point mémoire de telle sorte que le chemin conducteur se forme dans la partie centrale du point mémoire, loin des bords qui sont susceptibles de contenir des défauts. Cela peut être obtenu en pulvérisant l'oxyde $HfO_2$ selon une incidence oblique (par exemple à 45°) tout en faisant tourner le substrat sur lui-même, comme illustré sur la figure 10A. En effet, ce mode de dépôt permet d'obtenir une couche d'oxyde 125 ayant une épaisseur plus fine dans sa portion centrale 125a que sur ses bords 125b (Fig.10B). Le courant électrique est alors concentré au centre de l'élément de stockage, comme dans la couche barrière tunnel de l'exemple précédent.

Plutôt que d'obtenir une variation locale d'épaisseur, on peut chercher à modifier localement la composition d'un alliage entrant dans la fabrication des éléments de stockage.

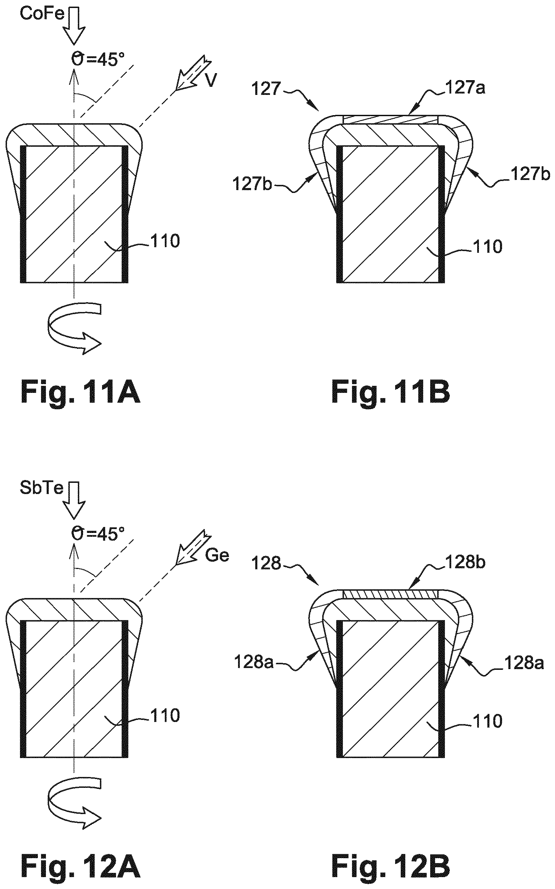

Sur les figures 11A et 11B, on prend à titre d'exemple une jonction tunnel magnétique pour mémoire magnétique à transfert de spin STT-MRAM. Dans ce type de mémoire, il est intéressant d'utiliser l'alliage CoFeV comme électrode de stockage, car le vanadium (V) est connu pour réduire le coefficient d'amortissement de Gilbert. Cela permet de réduire le courant d'écriture par transfert de spin (le courant d'écriture est proportionnel à ce coefficient d'amortissement). Par ailleurs, on sait que l'incorporation de vanadium dans l'alliage CoFe a pour effet de diminuer le moment magnétique du fer. Les propriétés magnétiques de l'électrode pourraient donc être modulées en faisant varier la teneur en vanadium dans l'alliage CoFeV.

Pour parvenir à un tel résultat, l'électrode peut être déposée par pulvérisation cathodique simultanée d'un alliage CoFe en incidence normale (non collimatée) et de vanadium en incidence oblique (par exemple à 45°), tout en faisant tourner le substrat sur lui-même (Fig.11A). Cela aboutit à une couche 127 d'alliage CoFeV dont la teneur en vanadium est plus faible dans sa portion centrale 127a que sur ses bords 127b (Fig.11B), grâce à une vitesse de dépôt du vanadium plus faible au centre que sur les bords. L'électrode 127 est alors formée d'un alliage CoFeV d'une première composition sur la partie centrale du pilier 110 (par exemple $Co_{60}Fe_{20}V_{20}$) et d'un alliage CoFeV d'une seconde composition à sa périphérie, ayant une plus forte concentration en vanadium (par exemple $Co_{40}Fe_{13}V_{47}$). Ce dernier alliage peut d'ailleurs devenir non magnétique s'il est très riche en vanadium, ce qui évite à nouveau d'être sensible aux défauts en bords de pilier, tels que les variations locales d'anisotropie magnétique.

Enfin, l'exemple représenté par les figures 12A et 12B concerne un élément de stockage de mémoire PCRAM. Dans une mémoire PCRAM, le matériau de stockage est un matériau à changement de phase, par exemple de type GeSbTe (différentes compositions de cet alliage sont possibles), ayant une structure stable à température ambiante soit dans un état amorphe, soit dans un état cristallisé. Ces deux états présentent des résistances électriques différentes, l'état amorphe étant bien plus résistif que l'état cristallisé (parfois 1000 fois plus résistif). La lecture est effectuée en mesurant le niveau de résistance du matériau à changement de phase, au moyen d'un courant électrique circulant à travers celui-ci. L'écriture du point mémoire se fait en appliquant une impulsion de courant de forme adaptée à l'état que l'on souhaite écrire. Une impulsion étroite suivie d'une trempe rapide depuis la température de liquéfaction du matériau conduit à l'état amorphe. Une impulsion longue à une température juste en dessous de la température de cristallisation suivie d'un refroidissement plus lent conduit à l'état cristallin. Par ailleurs, on sait qu'en augmentant la concentration de germanium (Ge) dans l'alliage, la température de cristallisation et la résistivité électrique dans l'état cristallisé augmentent.

Une couche de matériau à changement de phase présentant deux compositions différentes de l'alliage GeSbTe peut être obtenue en dirigeant vers le sommet du pilier 110 un flux de SbTe (non collimaté) selon une incidence normale et un flux de Ge selon une incidence oblique (ex. 45°) simultanément, comme illustré sur la figure 12A. Ce mode de dépôt forme une couche 128 de GeSbTe dont la portion centrale 128a est moins riche en germanium que ses bords 128b (Fig.12B). L'alliage situé aux bords 128b ayant une température de cristallisation plus élevée que celui au centre, la partie active du point mémoire est limitée à la portion centrale 128a de la couche mémoire 128. Comme précédemment, cela permet d'uniformiser les propriétés électriques entre les différents points mémoire.

Bien sûr, d'autres flux que ceux décrits précédemment peuvent être utilisés. Par exemple, une teneur variable en germanium peut être obtenue avec un flux en incidence normal de $Sb_2Te_3$ et un flux en incidence oblique de GeTe. Par ailleurs, en augmentant la teneur en antimoine (Sb) dans l'alliage GeSbTe, la vitesse d'écriture du point mémoire PCRAM augmente et la température de transition amorphe-cristallin diminue. En déposant l'antimoine en incidence normale et l'alliage GeTe en incidence oblique, on peut obtenir un alliage plus riche en Sb au centre du pilier qu'à son bord. Ainsi, la transition amorphe/cristallisé se produit préférentiellement au centre du plot.

De façon plus générale, un gradient latéral d'épaisseur peut être obtenu par pulvérisation cathodique d'une espèce chimique selon une incidence oblique, alors qu'un gradient latéral de composition chimique peut être obtenu par pulvérisation cathodique simultanée d'au moins deux espèces chimiques différentes suivant des incidences différentes, l'une étant oblique et l'autre normale. De préférence, l'angle θ d'inclinaison du flux oblique est compris entre 20° et 70°.

On notera par ailleurs que l'obtention d'un gradient d'épaisseur et/ou de composition chimique est indépendante de la forme des piliers et de la manière dont ils ont été obtenus. Ces modes de dépôt de l'élément de stockage sont en effet applicables quel que soit le profil des flancs : flancs rentrants (i.e. surplombants, à encoche ou en arc de cercle), droits ou même sortants. De plus, il n'est pas nécessaire de faire tourner le substrat sur lui-même si l'on ne cherche pas à obtenir un gradient d'épaisseur et/ou de composition symétrique, i.e. sur tous les bords des piliers.

L'utilisation de piliers évasés comme support au dépôt du matériau résistif élargit le champ d'applications des mémoires non volatiles. En effet, outre le fait que la fabrication d'une mémoire OxRAM, CBRAM, PCRAM ou MRAM est facilitée, il est désormais possible de former une mémoire hybride, i.e. qui comprend deux matrices de points mémoire de technologies différentes sur un même substrat.

A titre d'exemple, on peut associer à une matrice de points mémoire magnétiques MRAM une matrice de points mémoire PCRAM confinée en volume. Les mémoires PCRAM confinées sont une catégorie de mémoires à changement de phase dans laquelle la partie active du matériau à changement de phase est située sur une paroi latérale d'un espaceur en matériau diélectrique. Une telle structure permet d'optimiser la consommation électrique de la mémoire, en réduisant notamment le courant d'écriture de l'état isolant (courant de « reset »). Les mémoires PCRAM confinées ont fait l'objet de nombreuses études, notamment l'article [« A Scalable Volume-Confined Phase Change Memory using Physical Vapor Deposition », S.C. Lai, Symposium of VLSI Technology, 2013], mais n'ont jamais été associées à un autre type de mémoire jusqu'à présent.

L'avantage des mémoires hybrides MRAM/PCRAM est qu'on obtient dans un même composant une solution complète de mémoire non volatile, qui rassemble les forces de chaque type de mémoire, ici l'endurance et la vitesse de fonctionnement des MRAM d'une part, la faible consommation et la forte densité d'intégration des PCRAM confinées d'autre part. De telles mémoires hybrides permettent de remplacer les mémoires volatiles dans de nombreuses situations.

Pour fabriquer une mémoire hybride MRAM/PCRAM, une première portion du substrat contenant des piliers conducteurs évasés est consacrée à la formation des points mémoire magnétiques, selon le procédé décrit en relation avec les figures 4A à 4G. Les points mémoire PCRAM sont quant à eux formés dans une seconde portion du substrat, qui contient également des piliers conducteurs évasés. En d'autres termes, les piliers conducteurs sont répartis entre ces première et seconde portions du substrat. Les piliers conducteurs de la seconde portion sont recouverts d'un matériau à changement de phase, tandis que des jonctions tunnel magnétiques sont formées aux sommets des piliers de la première portion.

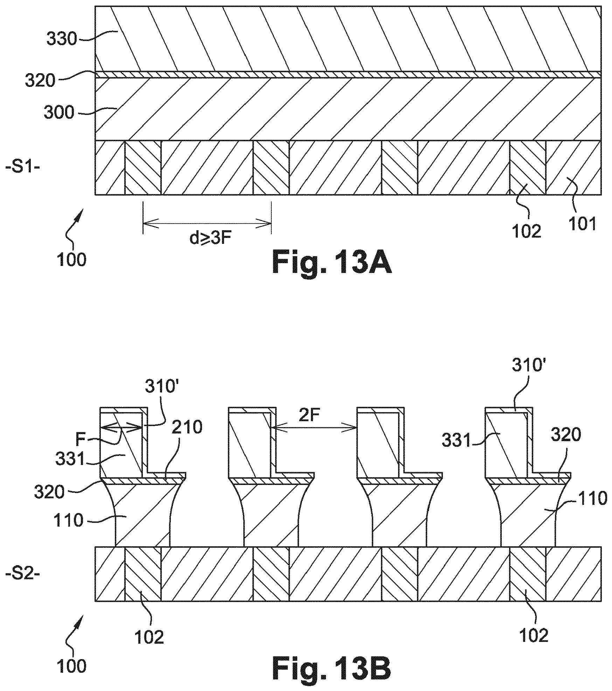

Un procédé de fabrication de la matrice PCRAM confinée va maintenant être décrit ci-dessous en référence aux figures 13A à 13F. Ce procédé et celui des figures 4A à 4G partagent un grand nombre de caractéristiques (les éléments en commun portent les mêmes signes de référence). De fait, ils sont compatibles entre eux et permettent d'intégrer les deux types de mémoire sur un même substrat.

Les informations données précédemment sur l'une quelconque des étapes des figures 4A et 4G, notamment leurs modes opératoires, sont applicables dès lors qu'une de ces étapes est reprise dans le procédé de fabrication de la matrice PCRAM confinée, même partiellement. On s'attachera donc ci-dessous à souligner les différences entre les deux procédés, plutôt que de répéter ces informations.

A l'étape S1 de la figure 13A, on dépose sur le substrat 100 de la figure 3 la première couche conductrice 300 destinée à former les piliers conducteurs. Avantageusement, la couche conductrice 300 est recouverte d'une couche de protection 320 empêchant la formation d'un oxyde ou nitrure isolant, par exemple en ruthénium (dans le cas d'un oxyde). Enfin, une couche diélectrique 330 est déposée sur la couche de protection 320.

Lors de l'étape S2 représentée par la figure 13B, des plots espaceurs 331 sont formés dans la couche diélectrique 330, par photolithographie et gravure. La gravure s'effectue par exemple par gravure plasma réactive avec arrêt sur la couche de ruthénium 320 sous-jacente. Elle peut être fortement anisotrope, auquel cas les espaceurs 331 ont des parois latérales perpendiculaires au plan du substrat. Le matériau diélectrique des espaceurs 331 est avantageusement un nitrure (ex. SiN), pour éviter qu'il n'oxyde le matériau à changement de phase qui recouvrira ultérieurement ces plots. De préférence, les plots espaceurs 331 ont une largeur égale à F et sont séparés par des tranchées de largeur égale à 2F. Ils sont donc espacés périodiquement, à l'instar des via conducteurs 102 du substrat 100 (leur période valant 3F).

Au cours de la même étape S2 (Fig.13B), un masque de gravure 310' (masque dur ou en résine) est formé sur les plots espaceurs 331 et une partie de la couche de protection 320 en ruthénium. Le masque 310' remplit le même rôle que le masque 310 de la figure 4B, sauf qu'il épouse ici la topographie de surface créée par la gravure de la couche diélectrique 330. Les parties pleines du masque 310', situées à l'aplomb des via conducteurs 102, se trouvent à cheval entre la couche de protection 320 et les plots espaceurs 331. Enfin, les couches 300 et 320 sont gravées à travers le masque 310' pour former les piliers conducteurs 110. Les conditions de gravure sont choisies de façon à former des flancs surplombants, comme décrit précédemment en relation avec la figure 4C.

On obtient alors, à l'issue de l'étape S2, des piliers évasés 110 dont la face supérieure est recouverte par la couche de protection 320 en ruthénium, elle-même étant partiellement recouverte par les plots espaceurs 331. De préférence, les espaceurs 331 sont tous situés d'un même côté des piliers 110 (par exemple le côté gauche sur la figure 13B) et ne dépassent pas du bord des piliers 110.

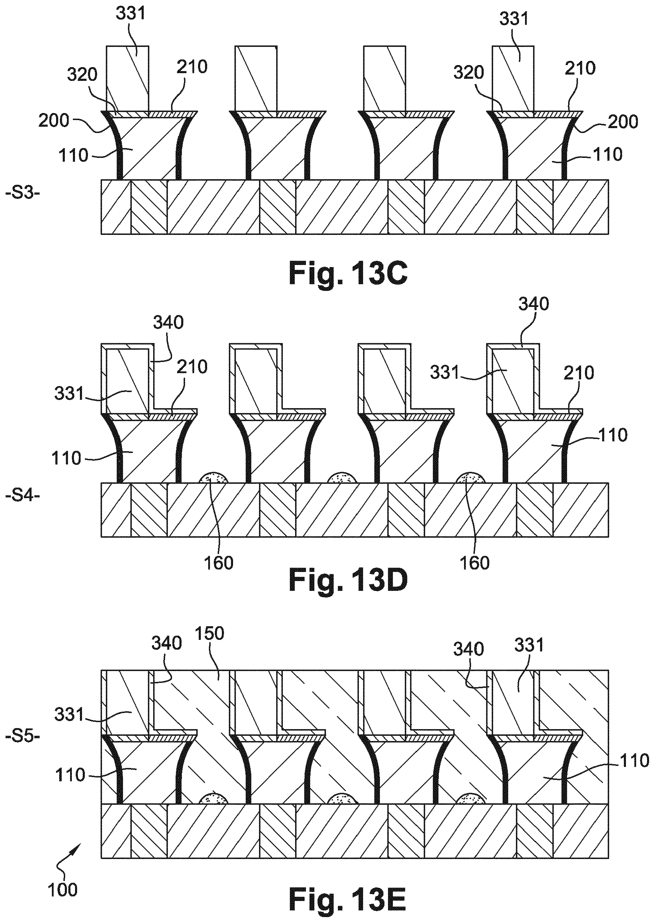

La figure 13C représente l'étape optionnelle S3 d'oxydation des flancs des piliers 110, après retrait du masque de gravure. Lorsque cette étape a lieu, la couche de protection 320 permet à la face supérieure des piliers 110 de rester conductrice électriquement. Dans l'exemple ci-dessus, un oxyde de ruthénium 210 se forme dans la portion de couche 320 disposée au sommet de chaque pilier 110 et non recouverte par le plot espaceur 331. Bien sûr, plutôt qu'un matériau dont l'oxyde est conducteur, la couche de protection 320 peut être formée d'un matériau dont le nitrure (référence 210) est conducteur (dans ce cas, l'étape S3 est une nitruration) ou d'un métal noble (l'oxydation ou la nitruration laisse intact la couche 320). Par ailleurs, une couche isolante en oxyde (ou nitrure) 200 se forme sur les flancs des piliers 110.

En S4 (Fig.13D), le matériau à changement de phase (PCM) est déposé par PVD, préférentiellement par pulvérisation cathodique, aux sommets des piliers 110 d'une part, et entre les piliers 110 d'autre part. Une couche 340 de PCM recouvre les espaceurs 331, y compris leurs parois latérales (du fait de l'ouverture angulaire de ce mode de dépôt), et la couche 210 en oxyde de ruthénium. Des dépôts résiduels 160 de matériau PCM se forment au fond des tranchées séparant les piliers 110.

Le dépôt PVD permet d'obtenir une couche de PCM 340 d'épaisseur sensiblement constante sur les parois latérales des plots espaceurs 331. En outre, la hauteur des plots espaceurs 331 (soit l'épaisseur de la couche diélectrique 330) est avantageusement comprise entre 50 nm et 100 nm. Cela permet d'obtenir un bon confinement thermique et donc de minimiser l'énergie à fournir pendant le fonctionnement de la mémoire.

Le courant de programmation du point mémoire diminue lorsque l'épaisseur de la couche de PCM 340 diminue. L'épaisseur de la couche de PCM 340 sur les parois latérales des plots espaceurs 331 est de préférence comprise entre 4 nm et 50 nm pour que la consommation électrique du dispositif mémoire soit maitrisée. La couche 340 déposée par pulvérisation cathodique présente généralement un rapport d'environ 2:1 entre l'épaisseur déposée sur la face supérieure des plots espaceurs 331 et l'épaisseur déposée sur leurs parois latérales. Ce rapport peut être diminué en formant des plots espaceurs 331 dotés de parois latérales inclinés plutôt que verticales. Le rapport tend alors vers 1:1 lorsque l'angle d'inclinaison des parois latérales (par rapport à la face supérieure des plots 331) se rapproche de 180°.

Le matériau à changement de phase est un alliage à base de matériaux chalcogénures, tel que le germanium, l'antimoine et le tellure (ex. GeSbTe, GeTe, GeSb, SbTe). Cet alliage peut être avec dopé avec un ou plusieurs autres éléments chimiques, tel que N, C, Si, Se, In, Sn, Ag, ou encore combiné avec un matériau diélectrique comme SiO, SiN et TiO.

Lors de l'étape S5 représentée par la figure 13E, les tranchées entre les piliers conducteurs 110 et entre les plots espaceurs 331 sont remplies par le matériau diélectrique 150. Auparavant, une couche barrière en nitrure (ex. SiN) peut être déposée sur le matériau PCM, afin de le protéger de l'oxydation par le matériau diélectrique (lorsque celui-ci est un oxyde). Cette couche barrière est particulièrement avantageuse dans le cas des PCRAM confinées, car la couche active de PCM est mince (4 - 50 nm).

Comme précédemment, il est préférable de recouvrir entièrement les nanostructures formées sur le substrat 100 avec le matériau diélectrique 150, puis d'aplanir la surface du matériau par polissage jusqu'à atteindre la surface des plots espaceurs 331 et la couche de PCM 340 qui recouvrent leurs flancs.

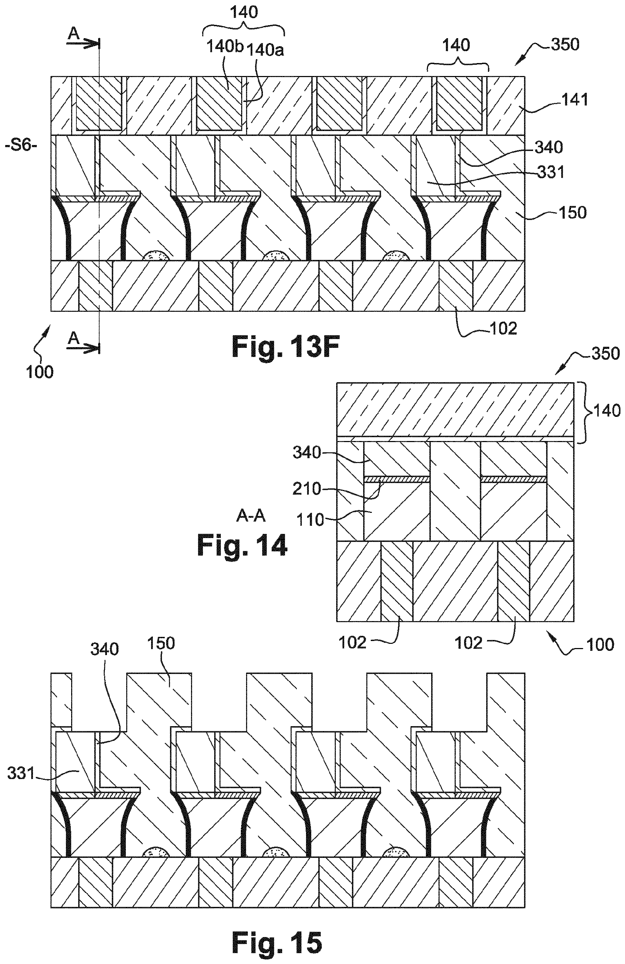

Enfin, en S6 (Fig.13F), un niveau de métallisation 350 est formé sur la surface plane du matériau diélectrique de remplissage 150. Ce niveau 350 peut comprendre des lignes métalliques 140, formant des contacts électriques pour plusieurs points mémoire simultanément, noyées dans une couche diélectrique 141. De préférence, chaque ligne métallique 140 du niveau 350 recouvre au moins une partie d'un plot espaceur 331 et la couche de PCM 340 disposée contre l'une des parois latérales de ce plot.

De préférence, le niveau de métallisation 350 est réalisé selon un procédé « damascène ». Les lignes métalliques 140 comprennent avantageusement une première couche de métal 140a ayant une bonne accroche sur le matériau à changement de phase (ex. Ti, Ta). Cette première couche 140a recouvre le fond et les parois latérales des tranchées formées dans la couche diélectrique 141. Puis, une seconde couche en métal 140b, ayant une conductivité supérieure à celle de la couche d'accroche 140a (ex. Al), constitue le coeur des lignes métalliques 140.

Ce niveau de métallisation 350 constitue généralement l'un des bus de lecture des points mémoire, soit le bus de mot (« word line ») soit le bus de bit (« bit line »), tandis que les motifs d'interconnexion 102 du substrat 100 sont des via conducteurs comme vu précédemment. Les lignes métalliques 140 du niveau 350 peuvent s'étendre perpendiculairement au plan de coupe de la figure 13F ou parallèlement à ce plan de coupe, suivant la façon dont l'autre niveau de métallisation (i.e. les via 102) a été défini.

La figure 14 représente à titre d'exemple deux points de mémoire PCRAM confinée situés dans le plan de coupe A-A de la figure 13F. Chaque point mémoire comprend successivement un pilier conducteur 110, une couche protectrice en RuO 210 et une couche de matériau PCM 340. Les deux points mémoire sont reliés électriquement au moyen du niveau de métallisation supérieur 350 mais peuvent néanmoins être individualisés grâce aux motifs d'interconnexion 102 du substrat 100.

Un certain nombre d'étapes du procédé de fabrication de la matrice mémoire MRAM (Figs.4A-G) et du procédé de fabrication de la matrice mémoire PCRAM confinée (Figs.13A-F) peuvent être mutualisés, afin de produire efficacement des mémoires hybrides MRAM/PCRAM. Comme les deux types de mémoire reposent sur des piliers conducteurs évasés, les étapes de formation de ces piliers dans la première portion et la deuxième portion du substrat peuvent être réalisées simultanément. L'étape de remplissage par le matériau diélectrique 150 (dépôt suivi d'une éventuelle planarisation) et l'étape de formation des contacts électriques 140 supérieurs sont d'autres exemples d'étapes pouvant être mutualisées.

Par conséquent, seules les étapes de formation des plots espaceurs 330 et du dépôt du matériau à changement de phase sont spécifiques au procédé de fabrication de la matrice mémoire PCRAM confinée. Lors de ces étapes, la première portion du substrat réservée aux points mémoire magnétiques peut être couverte par un matériau sacrificiel, et inversement lorsque c'est au tour des points mémoire magnétiques d'être formés. La couche de nitrure 330 est ainsi limitée à la portion réservée à la matrice PCRAM.

Lors de l'étape S5 d'ouverture des contacts (Fig.13E), le polissage mécano-chimique (CMP) peut altérer la couche 340 de matériau à changement de phase. En effet, on constate un phénomène de sur-gravure du matériau PCM, dû au fait que la solution abrasive (« slurry ») de planarisation réagit chimiquement avec le matériau PCM. Or, cette sur-gravure peut être préjudiciable pour former un contact électrique de qualité entre la couche confinée de matériau PCM et la ligne métallique du niveau d'interconnexion supérieur 350.

La figure 15 représente une autre façon, plus avantageuse, d'accéder à la couche confinée 340 de matériau PCM (et à la portion d'espaceur 331) pour y prendre le contact. Dans cette variante de mise en oeuvre de l'étape S5, la planarisation mécano-chimique du matériau diélectrique 150 est remplacée par une étape de gravure plasma. Cette étape de gravure est ici particulièrement simple à mettre en oeuvre, même lorsque les points mémoire sont très proches les uns des autres, car les points mémoire sont déjà individualisés grâce à l'utilisation des piliers. Les contraintes sur le masque de gravure peuvent donc être relâchées.

## Revendications

1. Procédé de fabrication d'un dispositif résistif, comprenant les étapes suivantes :

    - déposer (F1) une première couche électriquement conductrice (300) sur un substrat (100) ;
    - former (F2) un masque de gravure (310) sur la première couche conductrice (300) ;
    - graver (F3) au travers du masque (310) la première couche conductrice (300), de sorte à obtenir une pluralité de piliers électriquement conducteurs (110) espacés les uns des autres ; et
    - former (F5) des éléments de stockage (120) de résistance électrique variable aux sommets des piliers conducteurs (110), de sorte que chaque élément de stockage est supporté par l'un des piliers conducteurs,

    **caractérisé par**
    l'étape (F5) de formation des éléments de stockage (120) comprenant les opérations suivantes :

    ∘ déposer une première couche (121, 124) par pulvérisation cathodique non-collimatée sous une incidence normale par rapport au substrat (100) ; et
    ∘ déposer par pulvérisation cathodique une deuxième couche (122, 125, 127, 128) sur la première couche, la deuxième couche comprenant une première espèce chimique pulvérisée sous une incidence oblique.

2. Procédé selon la revendication 1, dans lequel la deuxième couche (127, 128) des éléments de stockage comprend une deuxième espèce chimique différente de la première espèce chimique et pulvérisée sous une incidence normale par rapport au substrat (100) en même temps que la première espèce chimique.

3. Procédé selon l'une des revendications 1 et 2, dans lequel le substrat (100) est entraîné en rotation lorsque la première espèce chimique est pulvérisée sous une incidence oblique.

4. Procédé selon l'une quelconque des revendications 1 à 3 dans lequel la première couche conductrice (300) est gravée de sorte que les piliers électriquement conducteurs (110) aient une section à leur base plus petite qu'à leur sommet.

5. Procédé selon la revendication 4, dans lequel la première couche conductrice (300) est gravée par gravure plasma réactive.

6. Procédé selon la revendication 5, dans lequel la première couche conductrice (300) est gravée par un plasma inductif généré en appliquant un champ électromagnétique radiofréquence d'une puissance comprise entre 100 W et 500 W sous une tension de polarisation comprise entre 15 V et 1 kV.

7. Procédé selon la revendication 5, dans lequel la gravure de la première couche conductrice (300) comporte successivement :

   - une gravure anisotrope d'une portion supérieure de la première couche conductrice (300), configurée de sorte à obtenir des flancs verticaux recouverts par une couche de passivation ;
   - une gravure isotrope d'une portion inférieure de la première couche conductrice (300), la gravure isotrope des flancs verticaux de la portion supérieure étant empêchée par ladite couche de passivation.

8. Procédé selon la revendication 5, dans lequel la première couche conductrice (300) comporte des sous-couches supérieure et inférieure formées de matériaux conducteurs différents, la gravure de la première couche (300) comportant successivement :

   - une gravure anisotrope de la sous-couche supérieure sélectivement par rapport à la sous-couche inférieure ;
   - une gravure isotrope de la sous-couche inférieure sélectivement par rapport à la sous-couche supérieure.

9. Procédé selon l'une quelconque des revendications 1 à 8, comprenant en outre les étapes suivantes :

   - déposer (F5) une deuxième couche électriquement conductrice sur les éléments de stockage (120), d'où il résulte des éléments de couverture (130) superposés aux éléments de stockage (120) ;
   - remplir (F6) l'espace entre les piliers conducteurs (110), entre les éléments de stockage (120) et entre les éléments de couverture (130) par un matériau diélectrique (150) ;
   - former (F7) un contact électrique (140) à la surface de chaque élément de couverture (130).

10. Procédé selon l'une quelconque des revendications 1 à 9, comprenant en outre une étape (F4) de formation d'une couche en matériau électriquement isolant (200) sur les flancs des piliers conducteurs (110).

11. Procédé selon la revendication 10, dans lequel dans lequel le matériau de la première couche conductrice (300) est choisi parmi le tantale, le tungstène, l'aluminium, le titane, le nitrure de titane et le silicium polycristallin dopé, et dans lequel la couche en matériau électriquement isolant (200) sur les flancs des piliers (110) est obtenue par oxydation du matériau de la première couche (300).

12. Procédé selon la revendication 11, comprenant le dépôt d'une couche en métal noble, en ruthénium ou en chrome sur la première couche (300), avant l'étape de formation du masque de gravure (310).

13. Procédé selon la revendication 10, dans lequel le matériau de la première couche (300) est le tantale ou le silicium polycristallin dopé, et dans lequel la couche en matériau électriquement isolant (200) sur les flancs des piliers (110) est obtenue par nitruration du matériau de la première couche (300).

14. Procédé selon la revendication 13, comprenant le dépôt d'une couche en titane sur la première couche (300), avant l'étape de formation du masque de gravure (310).

15. Procédé selon la revendication 10, dans lequel la couche en matériau électriquement isolant (200) sur les flancs des piliers (110) est obtenue par formation d'espaceurs diélectriques.

16. Procédé selon l'une quelconque des revendications 1 à 15, dans lequel la formation des éléments de stockage (120) aux sommets des piliers (110) comprend le dépôt d'une jonction tunnel magnétique dans une première portion du substrat (100) et le dépôt (S4) d'une couche de matériau à changement de phase (340) dans une seconde portion du substrat (100), le procédé comprenant en outre la formation (S2) de plots espaceurs (331) aux sommets des piliers (110) situés dans la seconde portion du substrat, avant le dépôt (S4) de la couche de matériau à changement de phase (340).

17. Procédé de fabrication d'un dispositif résistif, comprenant les étapes suivantes :

- former (F1') des structures verticales d'interconnexion (102', 110') de type damascène en matériau conducteur électriquement sur un substrat (100), lesdites structures verticales d'interconnexion étant réparties au sein d'une couche diélectrique (101, 103) ;
- amincir (F2') la couche diélectrique (101, 103) de sorte à libérer au moins partiellement lesdites structures verticales d'interconnexion (102', 110') ; et
- former (F3') des éléments de stockage (120) de résistance électrique variable aux sommets des structures verticales d'interconnexion (102', 110'), de sorte que chaque élément de stockage est supporté par l'une des structures verticales d'interconnexion,

**caractérisé par**
l'étape (F3') de formation des éléments de stockage (120) comprenant les opérations suivantes :

∘ déposer une première couche (121, 124) par pulvérisation cathodique non-collimatée sous une incidence normale par rapport au substrat (100) ; et
∘ déposer par pulvérisation cathodique une deuxième couche (122, 125, 127, 128) sur la première couche, la deuxième couche comprenant une première espèce chimique pulvérisée sous une incidence oblique.

18. Procédé selon la revendication 17, dans lequel la couche diélectrique (101, 103) est amincie au moyen d'une gravure isotrope et sélective par rapport au matériau conducteur.

19. Procédé selon l'une des revendications 17 et 18, dans lequel les structures verticales d'interconnexion (102', 110') de type damascène sont formées en déposant la couche diélectrique (101, 103) sur le substrat (100), en gravant des cavités dans la couche diélectrique (101, 103), en remplissant les cavités par le matériau conducteur et en supprimant par polissage l'excès de matériau conducteur en dehors des cavités.

20. Procédé selon la revendication 18, comprenant en outre une étape de dépôt d'une couche en matériau électriquement isolant (200) sur les parois latérales des cavités, avant le remplissage des cavités par le matériau conducteur.

**Patentansprüche**

1. Herstellungsverfahren einer ohmschen Vorrichtung, umfassend die folgenden Schritte:

- Aufbringen (F1) einer ersten elektrisch leitenden Schicht (300) auf ein Substrat (100);
- Bilden (F2) einer Gravurmaske (310) auf der ersten leitenden Schicht (300);
- Ätzen (F3) der ersten leitenden Schicht (300) durch die Maske (310) derart, dass eine Vielzahl von voneinander beabstandeten elektrisch leitenden Pfeilern (110) erhalten wird; und
- Bilden (F5) von Speicherelementen (120) mit variablem elektrischem Widerstand an den Spitzen der leitenden Pfeiler (110) derart, dass jedes Speicherelement durch einen der leitenden Pfeiler gestützt wird,
**gekennzeichnet durch** den Bildungsschritt (F5) der die folgenden Operationen umfassenden Speicherelemente (120):

∘ Aufbringen einer ersten Schicht (121, 124) per kathodischem, nicht kollimatiertem Aufsprühen unter einem normalen Einfall im Verhältnis zum Substrat (100); und;
∘ Aufbringen einer zweiten Schicht (122, 125, 127, 128) auf der ersten Schicht per kathodischem Aufsprühen, wobei die zweite Schicht eine unter einem schrägen Einfall aufgesprühte chemische erste Sorte umfasst.

2. Verfahren gemäß Anspruch 1, bei dem die zweite Schicht (127, 128) der Speicherelemente eine zweite, von der ersten chemischen Sorte unterschiedliche und unter einem im Verhältnis zum Substrat (100) normalen Einfall gleichzeitig mit der ersten chemischen Sorte aufgesprühten chemische Sorte umfasst.

3. Verfahren gemäß einem der Ansprüche 1 und 2, bei dem das Substrat (100) in Rotation angetrieben ist, wenn die erste chemische Sorte unter einem schrägen Einfall aufgesprüht ist.

4. Verfahren gemäß irgendeinem der Ansprüche 1 bis 3, bei dem die erste leitende Schicht (300) derart geätzt ist, dass die elektrisch leitenden Pfähle (110) einen Querschnitt haben, der an ihrer Basis kleiner ist als an ihrer Spitze.

5. Verfahren gemäß Anspruch 4, bei dem die erste leitende Schicht (300) per reaktiver Plasmagravur geätzt ist.

**6.** Verfahren gemäß Anspruch 5, bei dem die erste leitende Schicht (300) durch ein induktives Plasma geätzt ist, das durch Anwenden einer elektromagnetischen Funkfrequenz mit einer Leistung generiert ist, die zwischen 100 W und 500 W unter einer zwischen 15 V und 1 kV inbegriffenen Spannung inbegriffen ist.

**7.** Verfahren gemäß Anspruch 5, bei dem die Gravur der ersten leitenden Schicht (300) sukzessive umfasst:

- eine anisotrope Gravur eines oberen Abschnitts der ersten leitenden Schicht (300), die derart konfiguriert ist, dass von einer Passivierungsschicht abgedeckte vertikale Flanken erhalten werden;
- eine isotrope Gravur eines unteren Abschnitts der ersten leitenden Schicht (300), wobei die isotrope Gravur der vertikalen Flanken des oberen Abschnitts von der genannten Passivierungsschicht verhindert wird.

**8.** Verfahren gemäß Anspruch 5, bei dem die erste leitende Schicht (300) obere und untere Unterschichten umfasst, die aus unterschiedlichen leitenden Materialien gebildet sind, wobei die Gravur der ersten Schicht (300) sukzessive umfasst:

- eine im Verhältnis zur unteren Unterschicht selektive anisotrope Gravur der oberen Unterschicht;
- eine im Verhältnis zur oberen Unterschicht selektive isotrope Gravur der unteren Unterschicht.

**9.** Verfahren gemäß irgendeinem der Ansprüche 1 bis 8, umfassend darüber hinaus die folgenden Schritte:

- Aufbringen (F5) einer zweiten, elektrisch leitenden Schicht auf den Speicherelementen (120), woraus auf den Speicherelementen (120) überlagerte Abdeckelemente (130) resultieren;
- Befüllen (F6) des Raums zwischen den leitenden Pfeilern (110) zwischen den Speicherelementen (120) und zwischen den Abdeckelementen (130) durch ein dielektrisches Material (150);
- Bilden (F7) eines elektrischen Kontakts (140) an der Oberfläche jedes Abdeckelements (130).

**10.** Verfahren gemäß irgendeinem der Ansprüche 1 bis 9, umfassend darüber hinaus einen Bildungsschritt (F4) einer Schicht aus elektrisch isolierendem Material (200) auf den Flanken der leitenden Pfeiler (110).

**11.** Verfahren gemäß Anspruch 10, bei dem das Material der ersten leitenden Schicht (300) aus Tantal, Wolfram, Aluminium, Titan, Titannitrid und gedoptem Polykristallin-Silizium ausgewählt ist und bei dem die Schicht aus elektrisch isolierendem Material (200) auf den Flanken der Pfeiler (110) per Oxidation des Materials der ersten Schicht (300) erhalten wird.

**12.** Verfahren gemäß Anspruch 11, umfassend das Aufbringen einer Schicht aus Edelmetall, aus Ruthenium oder aus Chrom auf der ersten Schicht (300) vor dem Bildungsschritt der Gravurmaske (310).

**13.** Verfahren gemäß Anspruch 10, bei dem das Material der ersten Schicht (300) Tantal oder gedoptes Polykristallinsilizium ist und bei dem die Schicht aus elektrisch isolierendem Material (200) auf den Flanken der Pfeiler (110) per Nitrierung des Materials der ersten Schicht (300) erhalten wird ist.

**14.** Verfahren gemäß Anspruch 13, umfassend das Aufbringen einer Schicht aus Titan auf der ersten Schicht (300) vor dem Bildungsschritt der Gravurmaske (310).

**15.** Verfahren gemäß Anspruch 10, bei dem die Schicht aus elektrisch isolierendem Material (200) auf den Flanken der Pfeiler (110) per Bildung von dielektrischen Abstandshaltern erhalten wird.

**16.** Verfahren gemäß irgendeinem der Ansprüche 1 bis 15, bei dem die Bildung der Speicherelemente (120) an den Spitzen der Pfeiler (110) das Aufbringen einer magnetischen Tunnelverbindung in einem ersten Abschnitt des Substrats (100) und das Aufbringen (S4) einer Materialschicht mit Phasenänderung (340) in einem zweiten Abschnitt des Substrats (100) umfasst, wobei das Verfahren darüber hinaus die Bildung (S2) von Abstandshalter-Klötzen (331) an den Spitzen der Pfeiler (110), die in dem zweiten Abschnitt des Substrats angeordnet sind, vor dem Aufbringen (S4) der Materialschicht mit Phasenänderung (340), umfasst.

**17.** Herstellungsverfahren einer ohmschen Vorrichtung, umfassend die folgenden Schritte:

- Bilden (F1') der vertikalen Verbundstrukturen (102', 110') vom damaszenischen Typ aus elektrisch leitendem Material auf einem Substrat (100), wobei die vertikalen Verbundstrukturen innerhalb einer dielektrischen Schicht (101, 103) verteilt sind;
- Dünner machen (F2') der dielektrischen Schicht (101, 103) derart, dass die genannten vertikalen Verbundstrukturen (102', 110') wenigstens teilweise freigesetzt werden; und
- Bilden (F3') der Speicherelemente (120) mit variablem elektrischem Widerstand an den Spitzen der vertikalen Verbundstrukturen (102', 110') derart, dass jedes Speicherelement von einer der vertikalen Verbundstrukturen gestützt wird,

**gekennzeichnet durch** den Bildungsschritt (F3') der die folgenden Operationen umfassenden Speicherelemente (120):

◦ Aufbringen einer ersten Schicht (121, 124) per kathodischem, nicht kollimiertem Aufsprühen unter einem normalen Einfall im Verhältnis zum Substrat (100); und;
◦ Aufbringen einer zweiten Schicht (122, 125, 127, 128) auf der ersten Schicht per kathodischem Aufsprühen, wobei die zweite Schicht eine unter einem schrägen Einfall aufgesprühte chemische erste Sorte umfasst.

18. Verfahren gemäß Anspruch 17, bei dem die dielektrische Schicht (101, 103) mittels einer isotropen und selektiven Gravur im Verhältnis zum leitenden Material dünner gemacht wird.

19. Verfahren gemäß irgendeinem der Ansprüche 17 und 18, bei dem die vertikalen Verbundstrukturen (102', 110') vom damaszenischen Typ durch Aufbringen der dielektrischen Schicht (101, 103) auf dem Substrat (100) gebildet sind, indem in der dieleketrischen Schicht (101, 103) Vertiefungen geätzt werden, indem die Vertiefungen durch das leitende Material befüllt werden und indem der Überschuss von leitendem Material außerhalb der Vertiefungen per Polieren entfernt wird.

20. Verfahren gemäß Anspruch 18, umfassend darüber hinaus einen Aufbringschritt einer Schicht aus elektrisch isolierendem Material (200) auf den Seitenwänden der Vertiefungen vor dem Befüllen der Vertiefungen durch das leitende Material.

**Claims**

1. Method for manufacturing a resistive device, comprising the following steps:

- depositing (F1) a first electrically conductive layer (300) on a substrate (100);
- forming (F2) an etching mask (310) on the first conductive layer (300);
- etching (F3) the first conductive layer (300) through the mask (310), such as to obtain a plurality of electrically conductive pillars (110) separated from one another; and
- forming (F5) storage elements (120) of variable electrical resistance at the tops of the conductive pillars (110), such that each storage element is supported by one of the conductive pillars, **characterized by** the step (F5) of forming the storage elements (120) comprising the following operations:

◦ depositing a first layer (121, 124) by non-collimated cathode sputtering at normal incidence relative to the substrate (100); and
◦ depositing a second layer (122, 125, 127, 128) on the first layer by cathode sputtering, the second layer comprising a first chemical species sputtered at an oblique incidence.

2. Method according to claim 1, wherein the second layer (127, 128) of the storage elements comprises a second chemical species different from the first chemical species and sputtered at normal incidence relative to the substrate (100) at the same time as the first chemical species.

3. Method according to one of claims 1 and 2, wherein the substrate (100) is rotationally driven when the first chemical species is sputtered at an oblique incidence.

4. Method according to any of claims 1 to 3, wherein the first conductive layer (300) is etched such that the electrically conductive pillars (110) have a section at their base smaller than at their top.

5. Method according to claim 4, wherein the first conductive layer (300) is etched by reactive plasma etching.

6. Method according to claim 5, wherein the first conductive layer (300) is etched by an inductive plasma generated by applying a radiofrequency electromagnetic field of a power comprised between 100 W and 500 W under a bias voltage comprised between 15 V and 1 kV.

7. Method according to claim 5, wherein the etching of the first conductive layer (300) successively consists of:

- an anisotropic etching of an upper portion of the first conductive layer (300), configured such as to obtain vertical sides covered by a passivation layer;
- an isotropic etching of a lower portion of the first conductive layer (300), the isotropic etching of the vertical sides of the upper portion being prevented by said passivation layer.

8. Method according to claim 5, wherein the first conductive layer (300) comprises upper and lower sublayers formed of different conductive materials, the etching of the first layer (300) successively consisting of:

- an anisotropic etching of the upper sub-layer selectively with respect to the lower sub-layer;
- an isotropic etching of the lower sub-layer selectively with respect to the upper sub-layer.

9. Method according to any of claims 1 to 8, further comprising the following steps:

- depositing (F5) a second electrically conductive layer on the storage elements (120), resulting in covering elements (130) superimposed on the storage elements (120);
- filling (F6) the space between the conductive pillars (110), between the storage elements (120) and between the covering elements (130) with a dielectric material (150);
- forming (F7) an electrical contact (140) at the surface of each covering element (130).

10. Method according to any of claims 1 to 9, further comprising a step (F4) of forming a layer made of electrically insulating material (200) on the sides of the conductive pillars (110).

11. Method according to claim 10, wherein the material of the first conductive layer (300) is selected from tantalum, tungsten, aluminium, titanium, titanium nitride and doped polycrystalline silicon, and wherein the layer made of electrically insulating material (200) on the sides of the pillars (110) is obtained by oxidation of the material of the first layer (300).

12. Method according to claim 11, comprising the deposition of a layer made of noble metal, ruthenium or chromium on the first layer (300), before the step of forming the etching mask (310).

13. Method according to claim 10, wherein the material of the first layer (300) is tantalum or doped polycrystalline silicon, and wherein the layer made of electrically insulating material (200) on the sides of the pillars (110) is obtained by nitridation of the material of the first layer (300).

14. Method according to claim 13, comprising the deposition of a titanium layer on the first layer (300), before the step of forming the etching mask (310).

15. Method according to claim 10, wherein the layer made of electrically insulating material (200) on the sides of the pillars (110) is obtained by forming dielectric spacers.

16. Method according to any of claims 1 to 15, wherein the formation of storage elements (120) at the tops of the pillars (110) comprises the deposition of a magnetic tunnel junction in a first portion of the substrate (100) and the deposition (S4) of a layer of phase change material (340) in a second portion of the substrate (100), the method further comprising the formation (S2) of spacer pads (331) at the tops of the pillars (110) situated in the second portion of the substrate, before the deposition (S4) of the layer of phase change material (340).

17. Method for manufacturing a resistive device, comprising the following steps:

- forming (F1') vertical interconnection structures (102', 110') of damascene type made of electrically conductive material on a substrate (100), said vertical interconnection structures being distributed within a dielectric layer (101, 103);
- thinning (F2') the dielectric layer (101, 103) such as to free at least partially said vertical interconnection structures (102', 110'); and
- forming (F3') storage elements (120) of variable electrical resistance at the tops of the vertical interconnection structures (102', 110'), such that each storage element is supported by one of the vertical interconnection structures,

**characterized by** the step (F3') of forming storage elements (120) comprising the following operations:

○ depositing a first layer (121, 124) by non-collimated cathode sputtering at normal incidence relative to the substrate (100); and
○ depositing a second layer (122, 125, 127, 128) on the first layer by cathode sputtering, the second layer comprising a first chemical species sputtered at an oblique incidence.

18. Method according to claim 17, wherein the dielectric layer (101, 103) is thinned by means of an isotropic etching that is selective with respect to the conductive material.

19. Method according to one of claims 17 and 18, wherein the vertical interconnection structures (102', 110') of damascene type are formed by depositing the dielectric layer (101, 103) on the substrate (100), by etching cavities in the dielectric layer (101, 103), by filling the cavities with conductive material and by removing the excess of conductive material outside of the cavities by polishing.

20. Method according to claim 18, further comprising a step of depositing a layer made of electrically insulating material (200) on the lateral walls of the cavities, before filling the cavities with conductive material.

**Fig. 1**

**Fig. 2**

**Fig. 3**

$d \geq 3F$

**Fig. 4A**

**Fig. 4B**

**Fig. 4C**

**Fig. 4D**

130 — 120 — 110 — -F5- — 160 — 160

**Fig. 4E**

130 — 150 — 130 — 120 — 110 — -F6-

**Fig. 4F**

140 — 140 — 140 — 130 — 150 — 130 — 120 — 110 — -F7-

**Fig. 4G**

**Fig. 5**

**Fig. 6**

**Fig. 7A**

-F2'-

**Fig. 7B**

-F3'-

**Fig. 7C**

**Fig. 8**

**Fig. 9A**  **Fig. 9B**  **Fig. 9C**

**Fig. 10A**  **Fig. 10B**

**Fig. 11A**

**Fig. 11B**

**Fig. 12A**

**Fig. 12B**

330

320

300

-S1-

100

102    101

d≥3F

**Fig. 13A**

310'

310'

F

331

320

110

-S2-

100

210

2F

331    320

110

102    102

**Fig. 13B**

EP 3 210 246 B1

**Fig. 13C**

-S3-

**Fig. 13D**

-S4-

**Fig. 13E**

-S5-

100

31

**Fig. 13F**

**Fig. 14**

A-A

**Fig. 15**

## RÉFÉRENCES CITÉES DANS LA DESCRIPTION

**Documents brevets cités dans la description**

- US 6153443 A
- US 20140124881 A
- US 20080280411 A1

**Littérature non-brevet citée dans la description**

- **S.C. LAI.** A Scalable Volume-Confined Phase Change Memory using Physical Vapor Deposition. *Symposium of VLSI Technology,* 2013